(19) Europäisches Patentamt
European Patent Office
Office européen des brevets

(11) EP 2 650 938 A1

(12) EUROPEAN PATENT APPLICATION

(43) Date of publication:
**16.10.2013 Bulletin 2013/42**

(51) Int Cl.:
***H01L 51/05*** *(2006.01)*

(21) Application number: **12164095.7**

(22) Date of filing: **13.04.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Acreo Swedish ICT AB**
**164 40 Kista (SE)**

(72) Inventors:
- **Crispin, Xavier**
  **610 20 KIMSTAD (SE)**
- **Berggren, Magnus**
  **590 78 VRETA KLOSTER (SE)**
- **Sinno, Hiam**
  **602 32 NORRKÖPING (SE)**
- **Laiho, Ari**
  **00640 HELSINGFORS (FI)**
- **Coulembier, Olivier**
  **BE-7904 Pipaix (BE)**
- **Dubois, Philippe**
  **BE-5260 Braives (BE)**
- **Nguyen, Ha Tran**
  **BE-7000 Mons (BE)**

(74) Representative: **Andersson, Inga-Lill**
**Awapatent AB**
**P.O. Box 45086**
**104 30 Stockholm (SE)**

(54) **Organic Field-Effect Transistor Device**

(57) The invention relates to a organic field effect transistor (OFET) device comprising: an organic semiconductor layer; a source electrode arranged in electronic contact with the said organic semiconductor; a drain electrode arranged in electronic contact with the said organic semiconductor; a gate electrode; an electrolyte layer arranged between said gate electrode and said organic semiconductor layer; wherein the organic semiconductor layer comprises a semiconducting polymeric material comprising one or more blocks of conjugated polymer (SC) combined with one or more blocks of copolymer (B); preferably an amphiphilic copolymer. Also a method of producing the device, and a polyanionic polymer is provided by the invention.

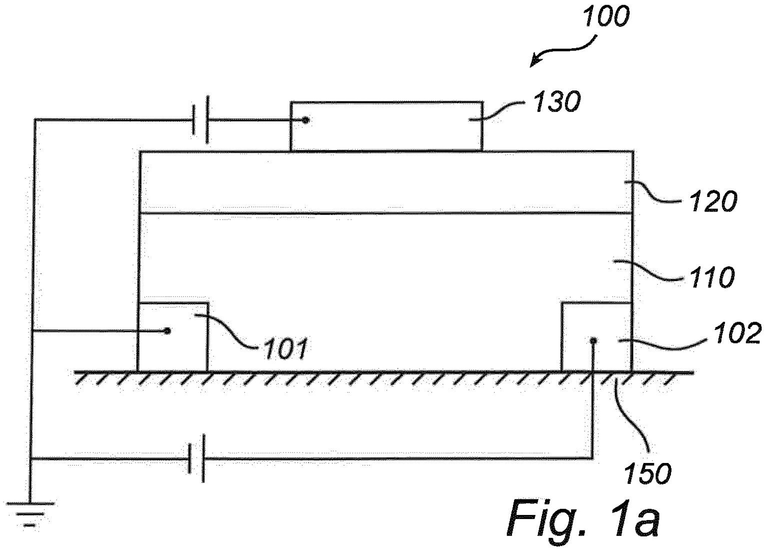


Fig. 1a

EP 2 650 938 A1

## Description

The technical field

The invention relates to organic field-effect transistor device comprising a semiconductor layer of semiconducting polymeric material, to a method for producing the device, to semiconducting polymeric materials and a method for producing the material.

Background art

There are organic field effect transistors (OFET) comprising polymeric semiconducting polymers known

Transistors comprising polyelectrolytes are previous known but problems with electrochemical effects may appear. Also, solutions to avoid the bulk electrochemistry have been presented and they have shown to be fast.

However, when the transistors are produced by printing processes they are difficult to process due to compatibility of the different materials included in the transistor, such as the hydrophilic polyelectrolyte and hydrophobic semiconductor.

A p-channel transistor is previously known for example from 'Polymer field-effect transistor gated via a poly (styrenesulfonic acid) thin film', E. Said, X. Crispin, L. Herlogsson, S. Elhag, N. D. Robinson, M. Berggren, Applied Physics Letters, 2006, 89 (14), 143507; or from 'Low-Voltage Polymer Field-Effect Transistors Gated via a Proton Conductor, L. Herlogsson, X. Crispin, N. D. Robinson, M. Sandberg, O.J. Hagel, G. Gustafsson, M. Berggren, Advanced Materials, 2007, 19(1), 97-101.

Attempts to improve the compatibility between the different components have been done, for example in "Controlling the dimensionality of charge transport in organic thin-film transistors ", A. Laiho, L. Herlogsson, R. Forchheimer, X. Crispin and M. Berggren, Proceedings of the National Academy of Sciences (PNAS), online. Herein it has been shown that conjugated polyelectrolytes have semiconducting properties with better wetting properties for polar solvent than closely related conjugated polymer without the electrolytic groups.

However, at low voltage, the transistor can be relatively fast but the current level reached is small due to the fact that the charge carrier mobility in conjugated polyelectrolyte is small since the electrolytic groups create many traps for the carrier. At higher voltage, the current is many order of magnitude larger but the conjugated polyelectrolyte shows a slow behavior in the transistors that will affect the properties of an electronic circuit. Hence, this limits the application of this type of transistor.

The aim with the present invention is to improve the processability of the transistor, thus the way to produce the transistor by modifying the wetting properties in the interface between a semiconducting material being hydrophobic and an electrolyte, for example a polyelectrolyte, being hydrophilic. By the invention it is provided an organic field effect transistor device, a method for its producing, wherein a polyelectrolyte is printed on an organic semiconductor in order to obtain a low voltage electrolyte gated organic field effect transistors showing good performances.

Commonly used materials in transistor devices are for example P3HT which is an organic semiconductor material. Also PSSH, a polyelectrolyte, is commonly used as transistor material. However, the materials have been shown to not be compatible with each other. There have been performed attempts to modify the components to increase the compatibility, and by that increase the performance during the fabrication of the transistor device.

When printing organic field effect transistors the step of contacting the semiconductor layer with the electrolyte is a crucial step. Challenging inherent wetting problem between a hydrophobic organic semiconducting polymeric material and a hydrophilic electrolyte may cause improper printing of the components to form an organic field effect transistor device.

The electrolyte, such as the polyelectrolyte, is considered to be hydrophilic as water is most often used as solvent carrier of the polyelectrolyte. Previously used semiconducting polymeric materials, for example conjugated polymers like P3HT are hydrophobic.

An improper printing may create an improper contact between the components, especially between the polyelectrolyte and the semiconductor may cause less proper performance of the transistor due to improper contact and transport of the electrons.

The aim with the present invention is to produce a semiconducting material with wetting compatibility between the semiconductor and the electrolyte together with

(i) a resulting fast transistor with substantially no hysteresis; and
(ii) a transistor which is mechanically stable.

One of the most crucial fabrication step is to create the interface between the semiconductor the electrolyte, where wettability incompatibilities have to be overcome and were smooth and homogenous interface is crucial and

important for the quality of the transistor.

Summary of the invention

By the present invention some of the drawbacks and deficiencies of the prior art organic field effect transistor devices are overcome. The invention provides an organic field effect transistor device comprising semiconducting polymeric material and to provide semiconducting polymeric material which is printable.

An embodiment of the invention is an organic field effect transistor (OFET) device. The device comprises:

an organic semiconductor layer;
a source electrode arranged in electronic contact with the said organic semiconductor;
a drain electrode arranged in electronic contact with the said organic semiconductor;
a gate electrode;
an electrolyte layer arranged between said gate electrode and said organic semiconductor layer;

wherein the organic semiconductor layer comprises a semiconducting polymeric material comprising one or more blocks of conjugated polymer (SC) combined with one or more blocks of copolymer (B).

An additional embodiment of the invention comprises a conjugated polymer of one or more blocks of conjugated polymer (SC) combined with one or more blocks of amphiphilic copolymer (B).

The semiconducting copolymer illustrated enables switching of the semiconducting film from hydrophobic to hydrophilic which facilitates deposition of a hydrophilic polyelectrolyte film on top of the semiconducting film.

The organic field effect transistor (OFET) device illustrated by the present invention is fast, due to that electrochemistry is substantially avoided. Further, substantially no hysteresis appears.

Further, solid electrolytes may be selected for the transistor, thus gel- like electrolytes may be avoided and the production of the transistor is improved and simplified.

When the polyelectrolyte has been applied upon the semiconducting material the wettability of the surfaces has shown to be improved.

An additional embodiment of the OFET device is that the conjugated polymer of the semiconducting material is of p-type. Thus the carrier of the charge in the semiconductor is positively charged (forming holes) as opposed to negatively charged (electrons i.e. n-type).

An additional embodiment of the OFET device is that the copolymer (B) of the semiconducting material is a polyanionic polymer (B1). Thus, typically, the polyanionic polymer may comprise monomer units having sulfonic acid, sulfuric acid, carboxylic acid, phosphonic acid, phosphoric acid, or maleic acid groups, or their salts thereof.

In an additional embodiment of the OFET the block copolymer is defined by formula Ia

$$SC\text{-}\ L_1\text{-}\ Z \qquad \text{formula Ia}$$

wherein the SC represents the semiconducting conjugated polymer;
Z represents the polyanionic copolymer; and
$L_1$ represents a linker anchoring the polyanionic copolymer to the conjugated polymer forming the semiconducting polymer.

A further embodiment is where the block copolymer is defined by formula Ib

$$\begin{array}{l} SC_p\text{-}L_1\text{-}(M_m\text{-}\ Q_n)\text{-} \\ \qquad\qquad\qquad\ \ | \\ \qquad\qquad\qquad\ \ A \end{array}$$

formula Ib

wherein the SC represents the semiconducting conjugated polymer;
$L_1$ represents a linker anchoring the polyanionic copolymer to the conjugated polymer forming the semiconducting polymer.
M represents a monomer unit forming the copolymer, and may be selected from the group of methyl methacrylate, styrene, vinylpyridine, and olefines;

Q represents monomer units carrying the anionic substituent in the copolymer;

A represents the anionic substituent. The anionic substituent may be selected from carboxylates, phosponates, phosphates, sulfates, and sulfonates. The list of anionic substituents is not exhaustive.

m represents an integer of between 0 and 100, preferably between 5 and 30, more preferably between 5 and 25;

n represents an integer of between 1 and 30, preferably between 1 and 20, more preferably between 1 and 10;

p represents an integer larger than 10, preferably larger than 40;

with the provisos that $m < p$, and $n < p$.

Additional embodiment of the invention is illustrated by that the polymer is regioregular poly (3- hexylthiophene) (P3HT) block and a hydrophilic block of randomly alternating repeat units of methyl methacrylate and sulfonated hydroxyethyl methacrylate (P (3HT)- *b*- P (MMA- *r*- HEMA: SBA) ) .

An embodiment of the device is wherein the organic semiconductor layer being a homogenous layer of the semiconducting material defined herein.

The device may also comprise a semiconductor layer comprising multiple layers of semiconducting material wherein a first layer comprising a semiconducting material of conjugated polymer, and a second layer comprising a semiconducting material comprising one or more blocks of conjugated polymer (SC) combined with one or more blocks of copolymer (B).

Also a method of producing the organic field effect transistor (OFET) device is provided by the invention comprising the steps:

- providing a substrate;
- applying one or more layers of organic semiconducting material;
- applying a source electrode to be arranged in electronic contact with the said organic semiconductor;
- applying a drain electrode to be arranged in electronic contact with the said organic semiconductor;
- apply an electrolyte layer;
- arrange a gate electrode so that the electrolyte layer is arranged between said gate electrode and said organic semiconductor layer.

The advantage provided by the method of producing the organic field effect transistor is that it has been simplified as one step in the printing method has been avoided. In previous known methods a step of applying a surface active agent to improve the compatibility between the semiconducting material and the polyelectrolyte has been mandatory.

In an additional embodiment the semiconducting polymeric material is according to formula Ic

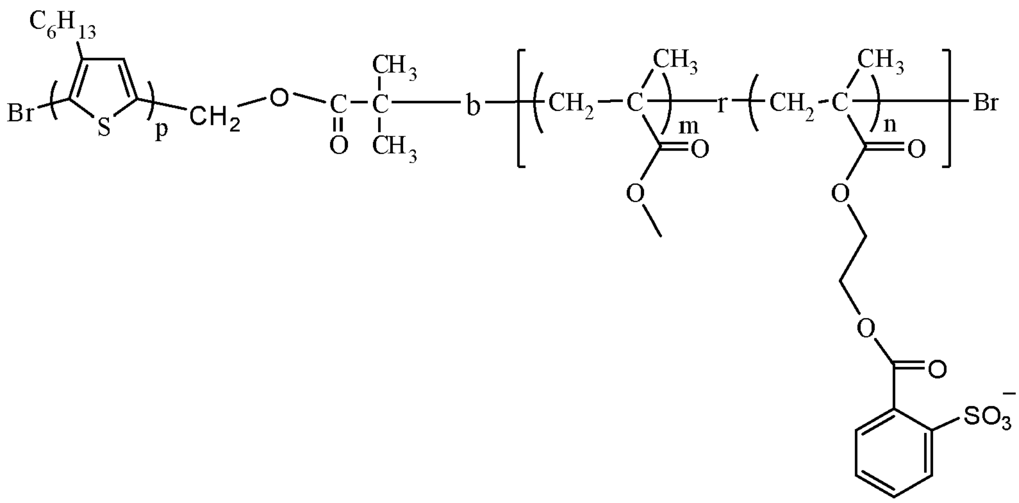

formula Ic

wherein

m represents an integer between 10 and 30;

n represents an integer between 3 and 15;

p represents an integer between 20 and 50;

preferably m represents 23; n represents 8; and p represents 43.

By the embodiments described above following advantages have been achieved. A fast transistor device showing substantially no hysteresis is obtained.The device comprises a solid electrolyte, therefore mechanical issues

which may appear with a gel-like electrolyte is avoided. Also, due to the amphiphilic properties of the organic semiconducting polymeric material the polyelectrolyte may be wetted in a proper way. The amphiphilic property is obtained by that the substituent is able to form charged groups upon exposure of suitable solvent, for example water or methanol.

Brief description of the Drawings

Figures 1A-1B illustrate different embodiments of OFET device arranged as top-gate/bottom-contact device.
Figures 2A-2B illustrate different embodiments of OFET device arranged as bottom-gate/top-contact device.
Figure 3 illustrates the surface wettability obtained by the anionic copolymer.
Figures 4A-4C illustrates the morphological characterization of the anionic copolymer (AFM).
Figures 5A-5C illustrates the characteristics of the OFET from Example 4, 5A-contact angle, 5B out-put characterization, and 5C transfer characterization.
Figures 6A-6B illustrates X-ray photoelectron spectroscopy XPS.
Figures 7A- 7B illustrates morphological characterization of untreated electrolyte; 7C-7D the electrolyte treated with the cationic copolymer.
Figures 8A and 8B illustrates optical microscopy (8A untreated surface, 8B treated surface).
Figures 9A and 9B illustrates the characteristics of the OFET from Example 6, 9A out-put characterization, and 9B transfer characterization.

Detailed description of preferred embodiments

Organic field-effect transistor devices (OFETs) are useful in organic electronic devices such as radio-frequency identification (RFID) tags, electronic paper, sensing devices and display backplanes. There are also advantages of using electrolytes as the gate dielectric material in OFETs are low-voltage operation, fast switching speeds and the fact that the performance of the electrolyte gated OFETs is not too sensitive to gate misalignment or to the variation of thickness or roughness of the gate dielectric layer thereby enabling robust manufacturing.

There are still needs to improve the method of producing the field effect transistors, especially regarding the compatibility of components included therein. Also when regarding transferring the technique intro large area processing, for example to change from spin-coating process to inkjet printing process. This challenge stems from the inherent incompatibility of the materials used: a hydrophobic semiconducting layer and a hydrophilic polyelectrolyte layer.

An embodiment illustrated herein includes amphiphilic semiconducting block copolymer which can be switched from hydrophobic to hydrophilic upon exposure to water. The wettability of the copolymer to inkjet print a hydrophilic polyelectrolyte film on the hydrophobic semiconducting copolymer surface has shown to be improved and useful when producing field-effect transistors.

Electric double layers form the basis for the operation of electrolyte-gated thin film transistors. As an example, when a negative voltage is applied to the gate of a p-type transistor, the positive ions of the electrolyte form one electric double layer together with the negative charges of the gate electrode while another double layer is simultaneously formed at the semiconductor interface, comprising of negatively charged ions of the electrolyte and holes of the semiconductor. The short distance between the oppositely charged sheets of the double layers gives rise to large electric fields, which enables low-voltage operation, whereas rapid formation of the electric double layers ensures fast operation of the electrolyte-gated transistors. Another significant advantage of using an electrolyte, especially for robust manufacturing processes, is that the transistor performance is not too sensitive to the thickness or roughness of the electrolyte layer, or to the alignment of the gate electrode.

By thorough selection of the electrolyte material it is possible to avoid electrochemical doping of the semiconductor where charged ions penetrate into the bulk of the semiconductor which leads to inferior transistor performance such as slow switching speed and large degree of hysteresis. This undesired electrochemical doping of the semiconductor can be largely diminished by choosing the electrolyte so that the ions that form the electric double layer with the charge carriers of the semiconductor, are immobile, e.g. in the case of a p- type or n- type transistor, a polyanion or a polycation, respectively, would meet the criteria. An alternative of electrolytes are polyelectrolytes, thus electrolytes having multiple of charges. They have an advantage over their oligomeric counterparts, namely that they have a film- forming characteristic which can be used in robust printing processes. According to an embodiment illustrated herein the electrolyte layer included in the device comprises an electrolyte selected from polyvinyl alcohol (PVA), poly acrylic acid (PAA), PCPhOH (poly (vinyl phenol), polyvinyl sulphonic acid (PVSH), poly (styrene- 4- sulphonic acid (PSSH), polysaccharide, preferably amylase, poly (vinylphosphonic acid- co- acrylic acid (P (VPA- co- AA) ), or mixtures thereof Typically, the polyelectrolyte is poly (vinylphosponic acid- co- acrylic acid (P (VPA- co- AA) ) .

The semiconducting material illustrated herein, comprises a block co polymer of conjugated polymer (SC) and

an amphiphilic copolymer (B) . The conjugated polymer may be any semiconducting conjugated polymer which is able to transport electrons. Examples of such polymers are: poly (alkylthiophene), poly (thienylene- vinylene), polyfluorene, polydiacetylene, poly (p- phenylene vinylene), or copolymers thereof. Typically, the conjugated polymer may be selected from the group consisting of poly- 3- alkylthiophenes, for example, poly3- hexylthiophene (P3HT), poly (thienylene-vinylene), polyfluorene, polydiacetylene, poly (p- phenylene vinylene), or mixtures thereof.

The list of conjugated polymers is not exhaustive.

The amphiphilic copolymer (B) may be a polyanionic copolymer (B1) or be a polycationic copolymer (B2).

The OFET device described herein may comprise a copolymer (B) of the semiconducting material being a polyanionic polymer (B1). Typically, the polyanionic polymer may comprise monomer units having sulfonic acid, sulfuric acid, carboxylic acid, phosphonic acid, phosphoric acid, or maleic acid groups, or their salts thereof.

In an additional embodiment of the OFET device comprising the block copolymer is wheren the block copolymer is defined by formula Ia

$$SC\text{-}L_1\text{-}Z \qquad \text{formula I}$$

wherein the SC represents the semiconducting conjugated polymer;
Z represents the polyanionic copolymer; and
$L_1$ represents a linker anchoring the polyanionic copolymer to the conjugated polymer forming the semiconducting polymer. A further embodiment is where
the block copolymer is defined by formula Ib

$$SC_p\text{-}L_1\text{-}(M_m\text{-}\ \underset{\displaystyle A}{\underset{|}{Q_n}})\text{-}$$

formula Ib

wherein the SC represents the semiconducting conjugated polymer;
$L_1$ represents a linker anchoring the polyanionic copolymer to the conjugated polymer forming the semiconducting polymer.
M represents a monomer unit forming the copolymer, and may be selected from the group of methyl methacrylate, styrene, vinylpyridine, and olefines;
Q represents monomer units carrying the anionic substituent in the copolymer;

A represents the anionic substituent. The anionic substituent may be selected from carboxylates, phosponates, phosphates, sulfates, and sulfonates. The list of anionic substituents is not exhaustive.
m represents an integer of between 0 and 100, preferably between 5 and 50, more preferably between 5 and 35.
n represents an integer of between 1 and 30, preferably between 1 and 20, more preferably between 1 and 10.
p represents an integer larger than 10, preferably larger than 40;
with the provisos that $m < p$, and $n < p$.

Additional embodiment of the invention is illustrated by that the polymer is regioregular poly (3- hexylthiophene) (P3HT) block and a hydrophilic block of randomly alternating repeat units of methyl methacrylate and sulfonated hydroxyethyl methacrylate (P (3HT)- *b*- P (MMA- *r*- HEMA: SBA) ) .

An example, the polyanionic copolymer is of formula Ic

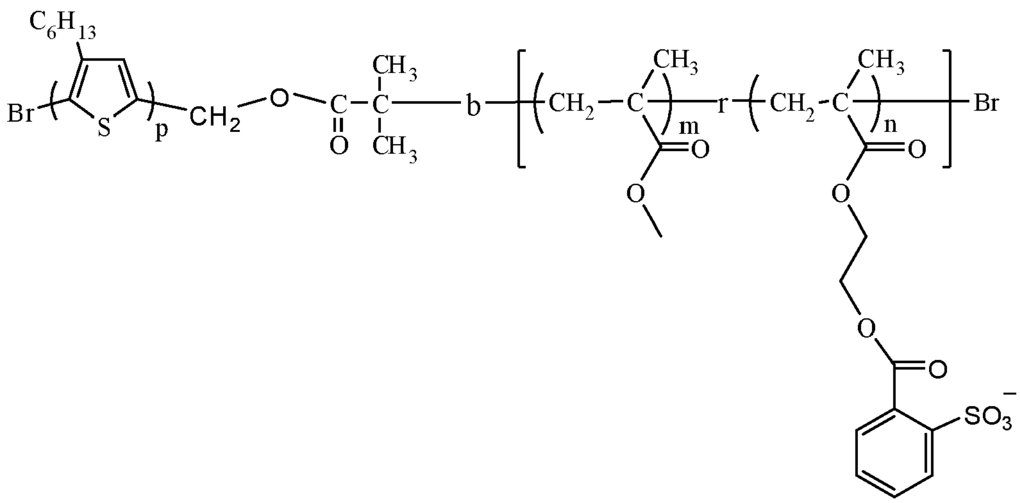

Formula Ic

wherein
m represents an integer between 10 and 30
n represents an integer between 3 and 15
p represents an integer between 20 and 50;
b denotes the block of units
r denotes that the units within brackets are randomized placed with the proviso that $m < p$; and $n < p$.

An embodiment of the inventions is where m represents 23; n represents 8; and p represents 43.

One of the semiconducting polymeric material illustrated herein may comprise copolymer consists of a hydrophobic semiconducting regioregular poly (3- hexylthiophene) (P3HT) block and a hydrophilic block of randomly alternating repeat units of methyl methacrylate and sulfonated hydroxyethyl methacrylate i.e. P (3HT)- *b*- P (MMA- *r*- HEMA: SBA) . The long semiconducting P3HT block is expected to facilitate formation of well- ordered structures, necessary for good electronic charge transport. The hydrophilic HEMA: SBA block, on the other hand, will change the surface wettability of the copolymer films for aqueous solutions thereby enabling inkjet printing of the polyelectrolytic gate dielectric from aqueous solutions. The HEMA: SBA block is designed so that it is long enough to change the wettability of the copolymer films but short enough so that the copolymer film does not dissolve when the polyelectrolyte layer is deposited on top from an aqueous solution.

This latter characteristic was tested by putting the polymer in distilled water and then analyzing the solution by FTIR and $^1$H-NMR after having filtered the solution through a microfilter The filtered solution was free from the copolymer which indicates that the copolymer is insoluble in water.

The surface wettability of the copolymer films may be determined by carrying out contact angle measurements wherein the water contact angle as a function of time after deposition of a water droplet on spin-coated surfaces of homopolymeric P3HT and the copolymer is shown. Further, the morphological characteristics of the copolymer surface may be analysed.

The organic field-effect transistor (OFET) described comprises a semiconducting material comprising a block copolymer comprising blocks of conjugated polymer and blocks of copolymer. The semiconducting material in the field-effect transistor is preferably a semiconducting organic material, for example a semiconducting polymer, wherein the polymer may be a conjugated polymer.

The semiconducting conjugated block copolymer comprises a "long block of a conjugated polymer" and a "short block of a polyanion". The amount or length of the conjugated polymer must be enough to create a crystallinity of the conjugated semiconducting polymer. That means the compositon of conjugated block (long block) is higher than 65% and short block of copolymer anion is lower than 35% by molecular weight determined by $^1$H NMR

The polyanionic polymer included in the semiconducting conjugated block copolymer is preferably a copolymer comprising repeating units substituted with anionic groups. The repeating units may be monomers selected from acrylic acid, methacrylic acid, phosphonic acid, sulphonic acid, maleic acid. In one embodiment the anionic polymer comprises an acid-functional groups or , or their different salt forms (like sodium salt, potassium salt, or the like). The anionic group may be selected from sulphonic acid, phosphonic acid, carboxylic acid, maleic acid or phosphoric acid.

The semiconducting conjugated polymer may be defined by formula Ia

$SC- L_1- Z$ Formula Ia

wherein the SC represents the semiconducting conjugated polymer as defined herein;
Z represents the polyanionic copolymer as defined herein; and
$L_1$ represents a linker anchoring the polyanionic copolymer to the conjugated polymer forming the semiconducting polymer.

The semiconducting conjugated copolymer may be further defined by formula Ib,

$$SC_p\text{-}L_1\text{-}(M_m\text{-}\ \underset{\substack{|\\ A}}{Q_n})\text{-}$$

Formula Ib

wherein the SC represents the semiconducting conjugated polymer;
$L_1$ represents a linker anchoring the polyanionic copolymer to the conjugated polymer forming the semiconducting polymer.
M represents a monomer unit forming the copolymer, and may be selected from the group of methyl methacrylate, styrene, vinylpyridine, and olefines;
Q represents monomer units carrying the anionic substituent in the copolymer;

A represents the anionic substituent. The anionic substituent may be selected from carboxylates, phosponates, phosphates, sulfates, and sulfonates. The list of anionic substituents is not exhaustive;
m represents an integer of between 0 and 100; preferably between 5 and 50; more preferably between 5 and 35;
n represents an integer of between 1 and 30; preferably between 1 and 20; more preferably between 1 and 10;
p represents an integer larger than 10; preferably larger than 40; for example an integer between 42 and 90
with the provisos that $m < p$, and $n < p$.

A may be further defined as- $L_2$- B- wherein $L_2$ represents a linker, for example formed by sulfobenzoic acid cyclic anhydride, or propane sulphone (1, 3- propanesulfone) ;
B represents the anionic substituent selected from acrylic acid, methacrylic acid, phosponic acid, sulphonic acid, maleic acid.

The monomers M and Q may be arranged in block or in random, preferably in random.

In one embodiment, the semiconducting material comprises the block copolymer of the following formula Ic :

The block copolymer, for example shown by formula Ib or Ic, may have a molecular weight ($M_w$) of about 10500 g/mol.

Additional embodiment of the invention is illustrated by that the polymer is regioregular poly (3- hexylthiophene) (P3HT) block and a hydrophilic block of randomly alternating repeat units of methyl methacrylate and sulfonated hydroxyethyl methacrylate (P (3HT)- *b*- P (MMA- *r*- HEMA: SBA) ) .

A further embodiment is where the block copolymer is defined by formula Ic

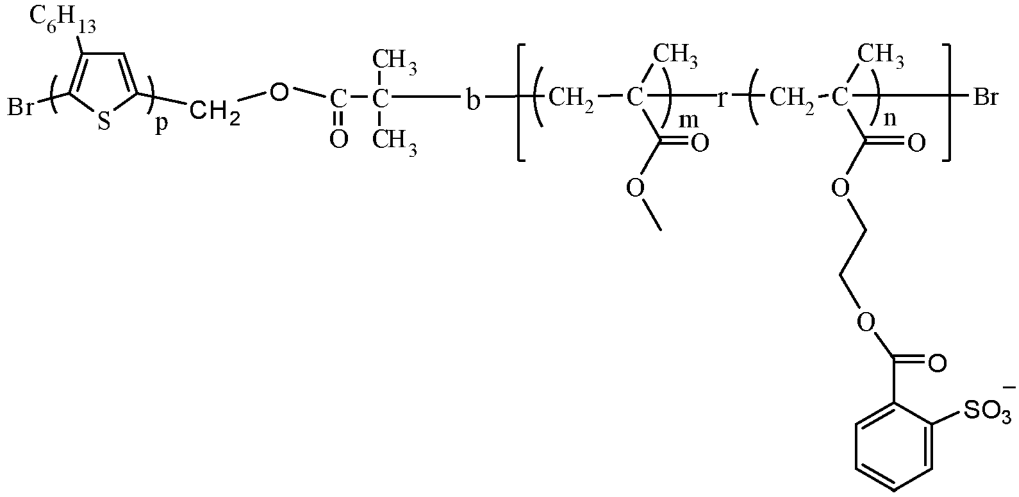

Formula Ic

wherein
m represents an integer between 10 and 30
n represents an integer between 3 and 15
p represents an integer between 20 and 50;
b denotes the block of units
r denotes that the units within brackets are randomized placed;
with the proviso that $m < p$; and $n < p$.

An embodiment of the inventions is where m represents 23; n represents 8; and p represents 43.

As described above the OFET device may comprise a semiconducting material wherein the copolymer (B) is a polycationic polymer (B2) . For example the cationic group may be a cationised alkylamine. The alkyl is typically selected from linear or branched $C_1$- $C_6$ alkyl, such $C_1$- $C_4$ alkyl, or $C_1$- $C_3$ alkyl. Examples are methyl, ethyl, n- propane, isopropane, n- butyl, isobutyl, tert- butyl. Further examples are N, N- dimethylamine, N- ethyl- N- methylamine, and N, N- diethylamine. The list is not exhaustive.

Further, the semiconducting conjugated polymer comprising polycationic copolymer may be represented by formula IIa

$SC- L_3- Y$ Formula IIa

wherein the SC represents the semiconducting conjugated polymer;
Y represents the polycationic homo- or copolymer; and
$L_3$ represents a linker anchoring the polycationic homopolymer or copolymer (Y) to the conjugated polymer forming the semiconducting polymer.

Further, the semiconducting conjugated polymer comprising polycationic copolymer may be represented by formula IIb wherein the cationic copolymer is of formula IIb

$SC_p$-$L_4$-( $X_n$)-
I
$A_2$

Formula IIb

wherein the SC represents the semiconducting conjugated polymer;
$L_4$ represents a linker anchoring the polycationic copolymer to the conjugated polymer forming the semiconducting polymer.

X represents a monomer unit forming the copolymer, and may be selected from methacrylate, styrene, vinylpyridine, or olefins.

$A_2$ represents the cationic substituent. The cationic substituent may be selected from alkylamines as described above.

n represents an integer of between 0 and 200, preferably between 50 and 150, more preferably between 70 and 125; p represents an integer larger than 10, preferably larger than 40. An example is where n represents 105; and p represents 42.

According to an embodiment of the invention the semiconducting conjugated polymer the block co polymer comprising cationic units is of formula IIc

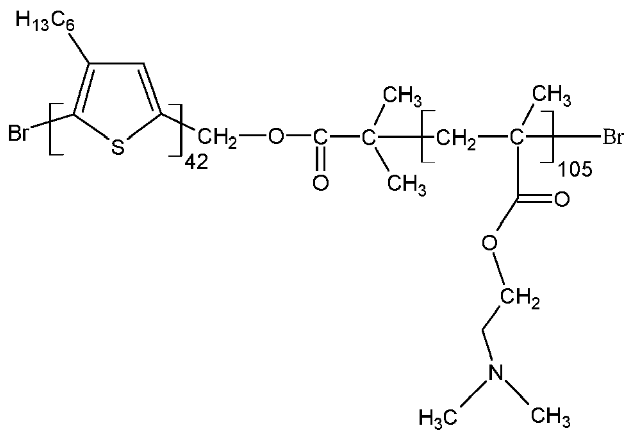

Formula IIc

By the term 'amphiphilic' and 'amphiphilic polymer' it is herein meant a material, such as a polymer, that has both hydrophilic and hydrophobic moieties which enables the change/ switch from hydrophobic to hydrophilic upon exposure to polar solvents, or mixtures of polar solvents. Examples of polar solvents are water, lower alcohols, for example ethanol, propanol, isopropanol. The amphiphilic polymer gives the semiconducting polymeric material dynamic wetting properties.

By the term 'semiconducting conjugated block copolymer' it is herein meant a polymer comprising one part of a conjugated polymer and one part of a polyanionic polymer, or a polycationic polymer. The semiconducting conjugated block copolymer has an electronic charge carrier mobility remaining through the layers of the semiconducting polymeric material and the polyelectrolyte.

The organic field effect transistor device comprises an electrolyte layer. The electrolyte may be selected from polyvinyl alcohol (PVA), poly acrylic acid (PAA), PCPhOH (poly (vinyl phenol), polyvinyl sulphonic acid (PVSH), poly (styrene- 4- sulphonic acid (PSSH), polysaccharide, preferably amylase, poly (vinylphosphonic acid- co- acrylic acid (P (VPA- co- AA) ), or mixtures thereof, as well as copolymers thereof. An example of polyelectrolyte is poly (vinylphosphonic acid- co- acrylic acid (P (VPA- co- AA) ) .

Figure 1 a schematically shows one embodiment of an organic field-effect transistor device (OFET) (100) according to the invention.

The OFET (100) shown in figure 1 is a so-called top-gate/bottom-contact type. The transistor comprises a source electrode (101) and a drain electrode (102), which both are in electronic contact with a semiconductor layer comprising a semiconducting polymeric material (110). The semiconducting material comprises the block copolymer of the invention.

An electrolyte (120) is arranged between said semiconducting material (110) and the gate electrode (130). The semiconducting material and the electrolyte are arranged in a way, that when a voltage is applied across said electrolyte said semiconductor material will become polarized, due to an electric double layer formed at the two surfaces of said electrolyte and said organic material which faces each other.

The semiconductor layer (110) is arranged as a homogenous layer of the semiconducting material comprising the block copolymer of conjugated polymer and the copolymer.

The semiconducting polymeric material in the semiconductor layer 110 may be selected from any of the semiconducting polymeric materials defined above, preferably the semiconducting polymeric material is P3HT- b- P (MMA- r- HEMA: SBA) .

The electrolyte in the electrolyte layer 120 may be selected from any of the electrolyte materials defined above, preferably the electrolyte material is poly (vinylphosphonic acid- *co*- acrylic acid) (P (VPA- AA) ) .

Optionally, the semiconductor layer may be divided into several layers comprising semiconducting material.

Figure 1b schematically shows another embodiment of the organic field-effect transistor (OFET) (100) according to the invention. Herein the semiconductor layer may be formed into two or more layers, an embodiment with two layers is shown in figure 1 b.

Also this OFET (100) is a so-called top-gate/bottom-contact type. The transistor comprises a source electrode (101) and a drain electrode (102), which both are in electronic contact with a semiconductor layer comprising a semiconducting polymeric material (110).

An electrolyte (120) is arranged between said semiconductor layer (110) and the gate electrode (130). The semiconducting material and the electrolyte are arranged in a way, that when a voltage is applied across said electrolyte said semiconductor material will become polarized, due to an electric double layer formed at the two surfaces of said electrolyte and said organic material which faces each other.

The semiconductor layer (110) is arranged in a layered manner. A first layer 111 being in contact with the source electrode (101) and drain electrode (102) comprises the semiconducting conjugated polymer. The second layer 112 comprises the semiconducting material comprising the block copolymer of conjugated polymer and the copolymer. This layer forms the interface with the electrolyte 120.

The semiconducting conjugated polymer may be the same or different in the different layers of the semiconductor layer. If the layers comprises different semiconductor material it is preferably to combine materials having similar surface properties.

The semiconducting polymeric material in the layered semiconductor layer 110 may be selected from any of the semiconducting polymeric materials defined above, preferably the semiconducting conjugated polymeric material in layer 111 is P3TH.

The semiconducting polymeric material being the copolymer may be selected from those as defined above, preferably the semiconducting polymeric material in layer 112 is P3HT- *b*- P (MMA- *r*- HEMA: SBA) .

The electrolyte in the electrolyte layer 120 may be selected from any of the electrolyte materials defined above, preferably the electrolyte material is poly (vinylphosphonic acid- *co*- acrylic acid) (P (VPA- AA) ) .

Figure 2a schematically shows another embodiment of an organic field-effect transistor device (OFET) (200) according to the invention.

The OFET (200) shown in figure 2a is a so-called bottom-gate/top-contact type. A gate electrode (230) is applied on, for example a substrate (250). The transistor comprises an electrolyte layer (220), wherein the electrolyte may be selected from any of the electrolyte materials defined above, for example the electrolyte material is poly(styrene sulfonic acid) (PSSH). A semiconductor layer (210) is applied upon the electrolyte. Then is a source electrode (201) and a drain electrode (202) arranged, which both are in electronic contact with a semiconductor layer comprising a semiconducting polymeric material (210).

The electrolyte (220) is arranged between said semiconducting material (210) and the gate electrode (230), and is are arranged in a way, that when a voltage is applied across said electrolyte said semiconductor material will become polarized, due to an electric double layer formed at the two surfaces of said electrolyte and said organic material which faces each other.

The semiconductor layer (210) is arranged as an homogenous layer of the semiconducting material comprising the block copolymer of conjugated polymer and the copolymer.

The semiconducting polymeric material in the semiconductor layer 210 may be selected from any of the semiconducting polymeric materials defined above, for example the semiconducting polymeric material is P3HT-b-PDMAEMA.

Optionally, the semiconductor layer may be divided into several layers comprising semiconducting material.

Figure 2b schematically shows another embodiment of the organic field-effect transistor (OFET) (200) according to the invention. Herein the semiconductor layer may be formed into two or more layers, an embodiment with two layers is shown in figure 2b.

Also this OFET device (200) shown in figure 2b is a so-called bottom-gate/top-contact type. A gate electrode (230) is applied on, for example a substrate (250). The transistor comprises an electrolyte layer (220), wherein the electrolyte may be selected from any of the electrolyte materials defined above, for example the electrolyte material is poly(styrene sulfonic acid) (PSSH). A semiconductor layer (210) is applied upon the electrolyte. Then is a source electrode (201) and a drain electrode (202) arranged, which both are in electronic contact with a semiconductor layer comprising a semiconducting polymeric material (210).

The electrolyte (220) is arranged between said semiconducting material (210) and the gate electrode (230), and is are arranged in a way, that when a voltage is applied across said electrolyte said semiconductor material will become polarized, due to an electric double layer formed at the two surfaces of said electrolyte and said organic material which faces each other.

The semiconductor layer (210) is arranged herein arranged in a layered manner. One layer (211) comprises layer of the conjugated polymer. The layer (212) forming the interface with the electrolyte comprises the semiconducting

material comprising the block copolymer of conjugated polymer and the copolymer.

The semiconducting polymeric material being the copolymer may be selected from those as defined above, preferably the semiconducting polymeric material in layer 212 is P3HT-b-PDMAEMA.

The electrolyte in the electrolyte layer 220 may be selected from any of the electrolyte materials defined above, preferably the electrolyte material is poly(styrene sulfonic acid) (PSSH).

The device may be placed on a substrate (150, 250) suitable for the organic field effect transistor. The substrate may be a solid substrate, for example made of silicon, glass or ceramics.

Another option is a flexible substrate, for example in form of a film or foil. Examples of flexible substrates are plastics, paper, cloth, thin sheet of metal, and membrane.

The material for the different electrodes described may be selected from commonly used electrode material, for example gold.

The organic field-effect transistor (OFET) may be arranged in reversed or opposite order than presented by the embodiments above.

The semiconducting material comprising the cationic copolymer may be synthesized according to the methods disclosed in Polym. Bull. (2011) 66:51-64, which more specifically describes the synthesis of P3HT based polycationic block copolymers comprising P3HT and PDMAEMA.

<u>Examples</u>

<u>Example 1: Synthesis of the semiconducting polymeric material, the amphiphilic copolymer P3HT-*b*-P(MMA-*r*-HEMA: SBA).</u>

Poly (3- hexylthiophene)- *block*- poly (methyl methacrylate- *random*- hydroxyethyl methacrylate) P3HT- b- P (MMA- r- HEMA) copolymer was synthesized by atom transfer radical copolymerization of methyl methacrylate and hydroxymethyl methacrylate from a P3HT- macroinitiator ($M_n$ $^1{}_{H\text{-}NMR}$ = 7200 g/mol, $Đ_M$ = 1.38) followed by an esterification of hydroxyl dangling groups with sulfobenzoic acid cyclic anhydride (SBA) to finally give P3HT- *b*- P (MMA- *r*- HEMA: SBA), ($M_n$ $^1{}_{H\text{-}NMR}$ = 10500 g/mol, $Đ_M$ = 1.39) .

The synthesis is further described in Examples 1A-1H

The materials used:

3- Hexyl thiophene, N- bromosuccinimide, iodine and iodobenzene diacetate were purchased from Acros and used as received. Ni (dppp) $Cl_2$, i- PrMgCl in tetrahydrofuran (THF) (2 mol/l) were also purchased from Acros and stored in glove box at room temperature. 2- Bromoisobutyryl bromide (Br- iBuBr),

triethylamine ($NEt_3$, 99%), n, n, n', n', n- pentamethyldiethylenetriamine (PMDETA, 99%), anhydrous N, N- dimethylformamide (DMF, 99.8%), sodium borohydride ($NaBH_4$, 99%) and phosphorus (V) oxychloride ($POCl_3$, 99%), 2- sulfobenzoic acid cyclic anhydride (SBA) were purchased from Aldrich.

Copper (I) bromide (CuBr, 98%) and copper (II) bromide ($CuBr_2$, 98%) were purchased from Fluka and used without further purification. Methyl methacrylate (Aldrich, 98%) was distilled under vacuum and stored under nitrogen at-20 °C. Chloroform (Labscan, 99%), toluene (Labscan, 99%), THF (Labscan 99%) were dried using an M Braun solvent purification system under $N_2$. Dichloromethane (Chem- Laboratory, 99, 8%), *n*- heptane (Labscan, 99%), n- hexane (Labscan, 99%) and methanol (Chem- Laboratory, 99.8%) were used as received. All reactions were performed in oven- dried glassware under purified nitrogen.

<u>Example 1A: *Synthesis* of *2-bromo-3-hexylthiophene*</u>

In a 200 ml flask, a solution of N- bromosuccinimide (5.29 g, 29.7 mmol) was slowly added to a solution of 3-hexylthiophene (5 g, 29.7 mmol) in 50 ml of anhydrous THF (50 ml) at 0°C under nitrogen. The mixture was stirred at 0 °C for 1 h. After that, 50 ml of distilled water was added to the reaction mixture, and the medium was extracted with 150 ml of diethyl ether. The organic layer was washed with a solution of $Na_2S_2O_3$ (10%), a solution of KOH (10%) and dried over anhydrous $MgSO_4$. The organic layer was distilled to give colourless oil. (6.7 g, 92%) .$^1$H NMR (300 Hz, $CDCl_3$), $\delta$ (ppm) : 7.19 (d, 1H), 6.82 (d, 1H), 2.59 (t, 2H), 1.59 (quint, 2H), 1.33 (m, 6H), 0.91 (t, 3H) . $^{13}$C NMR (300 Hz, $CDCl_3$), $\delta$ (ppm) : 141.0, 128.2, 125.1, 108.8, 31.6, 29.7, 29.4, 28.0, 22.6, 14.1.

<u>Example 1B: *Synthesis* of *2-bromo-3-hexyl-5-iodothiophene*</u>

Iodine (1.42g, 11.18 mmol) and iodobenzene diacetate (1.965 g, 6.1 mmol) were added to a solution of 2-bromo- 3- hexylthiophene (2.5, 11.1 mmol) in dichloromethane (25ml) at 0°C. The mixture was stirred at room temperature for 4 h. Then aqueous $Na_2S_2O_3$ (10%) was added, and the mixture was extracted with diethyl ether and dried over

anhydrous $MgSO_4$. Then the solvent was evaporated to obtain crude products, which were purified by silica column chromatography (eluent: heptane) to give pure 2- bromo- 3- hexyl- 5- iodothiophene as a pale yellow oil. (3 g, 86%) .$^1$H NMR (300 Hz, $CDCl_3$), δ (ppm) : 6.97 (s, 1H), 2.52 (t, 2H), 1.56 (quint, 2H), 1.32 (m, 6H), 0.89 (t, 3H) . $^{13}$C NMR (300 Hz, $CDCl_3$), δ (ppm) : 144.3, 137.0, 111.7, 71.0, 31.5, 29.6, 29.2, 28.8, 22.5, 14.1.

Example 1C: Synthesis of regioregular head-to-tail poly(3-hexylthiophene with H/Br end group (Br-P3HT-H)

A dry, 500 ml three- neck flask was flushed with nitrogen and was charged with 2- bromo- 3- hexyl- 5- iodothiophene (15 g, 40 mmol) . After three azeotropic distillations by addition of toluene (15 ml), 220 ml of anhydrous THF was added via a previously flamed and nitrogen flushed syringe, the mixture was stirred at 0°C for 1 h. i- PrMgCl (2 M solution in THF, 19.14 ml, 38.28 mmol) was added via a syringe and the mixture was continuously stirred at 0 °C for 1 h. The reaction mixture was allowed to cool down to 0 °C. The mixture was transferred to a flask containing a suspension of Ni (dppp) $Cl_2$ (760 mg, 1.4 mmol) in THF (25 ml) . The polymerization was carried out for 24 h at 0 °C followed by addition of 20 ml of 5 M HCl solution. After termination, the reaction was stirred for 15 min and extracted with 200 ml chloroform. The solvent was evaporated and the polymer was precipitated in cold methanol and washed several times with n- hexane (200 ml) . The polymer was characterized by $^1$H NMR and GPC. Yield: 70%.

FT- IR ($cm^{-1}$) : 721, 819, 1376, 1454, 1510, 2853, 2922, 2953. $^1$H NMR (300 Hz, $CDCl_3$), δ (ppm) : 6.96 (s, 1H), 2.90 (t, 2H), 1.79 (sex, 2H), 1.52 (q, 6H), 0.94 (t, 3H) . $M_{n,\ GPC}$, 6000 g/mol, $Đ_M$ = 1.18.

Example 1D: Synthesis of regioregular head-to-tail poly(3-hexylthiophene) with CHO/Br end group (Br-P3HT-CHO)

Br- P3HT- H (1 g, 16.6 x $10^{-5}$ mol) was dissolved in 260 ml of anhydrous toluene under nitrogen. N, N- dimethylformamide (DMF) (5.12 ml , 66.3 mmol) and phosphorus (V) oxychloride ($POCl_3$) (5.30 ml, 58 mmol) were then added to the solution. The oxidation reaction was performed at 75 °C for 24 h. Then the solution was cooled down to room temperature, followed by the addition of a saturated aqueous solution of sodium acetate (200 ml) . The solution was stirred for 4 h. Then, the polymer was extracted with 200 ml of chloroform. The solvent was evaporated under vacuum and the polymer was precipitated in cold methanol and washed with cold n- hexane (200 ml) . After drying under vacuum, 96 mg of polymer was obtained. Yield: 93%. FT- IR ($cm^{-1}$) : 721, 819, 1376, 1453, 1509, 1649, 2854, 2923, 2953. $^1$H NMR (300 MHz, $CDCl_3$) ; δ (ppm) : 9.99 (s, 1H), 6.96 (s, 1H), 2.78 (t, 2H), 1.69 (sex, 2H), 1.49 (q, 6H), 0.89 (t, 3H) . $M_{n\ GPC}$ = 6000 g/mol, $Đ_M$ = 1.19.

Example 1E: Synthesis of regioregular head-to-tail poly(3-hexylthiophene) with $CH_2OH$/Br end group (Br-P3HT-$CH_2OH$)

Br- P3HT- CHO (500 mg, 8.33 x $10^{-5}$ mol) was dissolved in 30 ml of anhydrous THF under nitrogen. After addition of $NaBH_4$ (41.8 mg, 1.1 x $10^{-3}$ mmol) the mixture was kept stirring at room temperature for 2 h. After evaporation of the solvent the polymer was precipitated in cold methanol. After drying under vacuum, 480 mg of the polymer was obtained. Yield: 96%. FT- IR ($cm^{-1}$) : 724, 817, 1376, 1453, 1509, 1561, 2853, 2922, 2953. $^1$H NMR (300 MHz, $CDCl_3$) ; δ (ppm) : 6.96 (s, 1H), 2.78 (t, 2H), 3.7 (t, 2H), 1.69 (sex, 2H), 1.49 (q, 6H), 0.89 (t, 3H) . $M_{n\ GPC}$ = 6000 g/mol, $Đ_M$ = 1.19.

Example 1F: Synthesis of bromoester-terminated poly(3-hexylthiophene) (P3HT-macroinitiator)

Br- P3HT- $CH_2OH$ (480 mg, 8.0 x $10^{-5}$ mol) was dissolved in 20 ml of anhydrous THF under nitrogen. To this solution $NEt_3$ (1 mmol) and 2- bromoisobutyryl bromide (0.83 mmol) were added. Then the reaction was carried out at 50 °C overnight, the polymer was extracted by chloroform. The solution was washed two times with distilled water. The polymer was precipitated in cold methanol. After drying under vacuum, 475 mg of the polymer was obtained. Yield: 95%. FT- IR ($cm^{-1}$) : 724, 818, 1376, 1451, 1509, 1561, 1735, 2853, 2922, 2953. $^1$H NMR (300 MHz, $CDCl_3$) ; δ (ppm) : 6.96 (s, 1H), 5.29 (t, 2H), 2.78 (t, 2H), 1.93 (t, 6H), 1.69 (sex, 2H), 1.49 (q, 6H), 0.89 (t, 3H) . $M_{n\ GPC}$ = 7000 g/mol, $Đ_M$ = 1.28, $M_{n\ ^1H\text{-}NMR}$ = 7200 g/mol

Example 1G: Synthesis of poly(3-hexylthiophene)-b-poly(methylmethacrylate-random-2-hydroxyethyl methacrylate) (P3HT-b-P(MMA-r-HEMA))

P3HT- b- P (MMA- r- HEMA) was synthesized by ATRP using the P3HT- macrointiator. 0.1 g of P3HT- macrointiator ($M_{n\ ^1H\text{-}NMR}$ = 7200, $Đ_M$ = 1.28) was placed in a 25 ml flask, to which 2 ml of degassed THF was added by syringe. The macroinitiator solution was stirred until it became homogeneous. Monomer solution was prepared separately: methacrylate (0.897 mmol, 90 mg), HEMA (0.08 mmol, 11 mg), PMDETA (0.028 mmol), CuBr (2 mg, 0.014 mmol) and a small amount of Cu (II) $Br_2$ (0.1 mg) were added in a 50 ml roundbottom flask, and the flask was degassed by three freeze- pump- thaw cycles. The monomer solution was stirred until it became homogeneous, and then placed in a 70

°C oil bath. When the macroinitiator solution was added by cannula into the monomer solution, the mixture solution became homogeneous with a dark orange color. After the solution was allowed to react for 16 h at 70 °C, the resultant polymer solution was diluted with 20 ml of THF. The solution was then passed through a column of $Al_2O_3$ to remove copper. The polymer solution was concentrated and then precipitated into n- hexane (50 ml) . The precipitated polymer was collected by vacuum filtration and subsequently washed with n- hexane and methanol, followed by drying under vacuum to give 165 mg of the desired product corresponding to 64% of conversion. FT- IR ($cm^{-1}$) : 724, 818, 1376, 1451, 1509, 1561, 1735, 2853, 2922, 2953, 3550. $^1H$ NMR (300 MHz, $CDCl_3$) ; δ (ppm) : 6.96 (s, 1H), 5.30 (t, 2H), 4.18 (s, 2H), 3.85 (s, 2H), 2.78 (s, 2H), 1.98 (m, 6H), 1.69 (sex, 2H), 1.49 (q, 6H), 0.89 (t, 3H) . $M_{n\ GPC}$ = 8550 g/mol, $Đ_M$ = 1.39, $M_n\ {}^1{}_{H\text{-}NMR}$ = 10500. Composition of the copolymer by $^1H$- NMR: P3HT (69%), PMMA (22%) and PHEMA (9%) .

Example 1H: Esterification of P3HT-b-P(MMA-r-HEMA) block copolymers

All of esterification reactions were carried out in THF at room temperature. For a typical reaction, 60 mg of copolymers was dissolved in 20 ml of THF and purged by $N_2$. Once the copolymers were dissolved in the solvent, $NEt_3$ (2 equiv to HEMA) was added. 2- sulfobenzoic acid cyclic anhydride (SBA) (2 equiv to HEMA) in about 10 ml of THF was then slowly added into the reactor with $NEt_3$ as the catalyst. The solution turned turbid immediately, and the reaction was stopped after 24 h. The copolymers were directly precipitated in n- hexane to obtain the sulfonated copolymers. Yield: 95%. FT- IR ($cm^{-1}$) : 724, 818, 1090 1376, 1451, 1509, 1561, 1735, 2853, 2922, 2953. $^1H$ NMR (500 MHz, $CDCl_3$) ; δ (ppm) : 9.8 (s, 1H), 8.1 (s, 2H), 7.5 (s, 2H), 6.96 (s, 1H), 4.25 (m, 2H), 4.18 (s, 2H), 3.85 (s, 2H), 3.1 (s, 6H), 2.78 (s, 2H), 1.98 (m, 6H), 1.69 (sex, 2H), 1.49 (q, 6H), 0.89 (t, 3H) .

Example 2:

Determination of surface wettability of films comprising the anionic copolymer

The surface wettability of the copolymer films obtained by Examples 1A-1H was determined by carrying out contact angle measurements. Figure 2a shows the water contact angle as a function of time after deposition of a water droplet on spin-coated surfaces of homopolymeric P3HT and the copolymer.

As a reference, the homopolymeric P3HT surface was expectedly hydrophobic and the water contact angle remained constant at 104° throughout the duration of the experiment.

The water contact angle on the copolymer surface was high, at first, but after a couple of seconds the water droplet collapsed and the surface suddenly changed from hydrophobic to hydrophilic as evidenced by the abrupt drop of contact angle from 95° to 18°, shown in figure 3a). Next, aqueous polyelectrolyte solutions were inkjet printed on the copolymer surface to address whether this wetting property can be exploited in depositing a polyelectrolyte layer on top of the copolymer surface.

Figure 3b visualizes the challenge in depositing a uniform polyelectrolyte film on the hydrophobic P3HT homopolymer. Despite using a surfactant to reduce the water contact angle, the polyelectrolyte does not form a uniform film on the P3HT surface but rather it confines to small islands b), which would inevitably lead poor transistor performance. However, the situation is strikingly different for the copolymer surface which allows inkjet printing of a uniform polyelectrolyte film on the copolymer surface as is evidenced by Figure 3c.

Example 3

Morphological characterization of the copolymer surface was carried out to investigate the origin of the abrupt change in surface wettability from hydrophobic to hydrophilic. The surface was investigated with an Atomic force microscopy (AFM). The result is shown in Figure 4, AFM phase images of the copolymer surfaces. Figure 4a illustrates the copolymer surface before, and Figure 4b after, deposition and extraction of a water droplet on the copolymer surface. The phase angle varies from 0 to 15 degrees and the scan size is (a) 1 μm x 1 μm and (b) 0.5 μm x 0.5 μm. The film appears to be amorphous but it also shows faint fibrous-like structures where the lateral width of a fiber is 15±5 nm which is in well accordance with the typical dimensions of homopolymeric P3HT nanofibrillar domains.

Similar surface reconstruction of amphiphilic copolymer surfaces and associated change in the surface wettability under exposure to water has been earlier reported by Nakahama and coworkers but not for any organic semiconductor materials [X. Han, C. Y. Luo, Y. Gao, H. L. Liu, J. Macromol. Sci. Part B-Phys. 2010, 49,440.; H. Mori, A. Hirao, S. Nakahama, K. Senshu, Macromolecules 1994, 27, 4093.].

Example 4:

Producing a field-effect transistor of top-gate/bottom-contact type comprising the anionic copolymer.

Poly (vinylphosphonic acid- *co*- acrylic acid) (P (VPA- AA) ) polyelectrolyte was obtained from Rhodia and used without further purification.

The device: To fabricate the top-gate/bottom-contact OTFTs, a chromium layer (5 nm thick) and a gold layer (50 nm thick) were first evaporated on a borosilicate glass substrate. Interdigitated source and drain electrodes were next patterned on the glass substrates by using standard photolithography and wet-etching. The copolymer was dissolved in a mixture of analytical grade tetrahydrofuran (THF) and methanol (9:1 vol:vol), sonicated and finally filtered through a 0.2 $\mu$m PTFE filter. The copolymer solutions were spin-coated on the patterned substrates and the resulting thin films were dried in a nitrogen oven at 110 °C for 10 min. The thickness of the copolymer film was 30$\pm$2 nm as measured by an ellipsometer (Sentech SE400). Polyelectrolyte P(VPA-AA) was dissolved (30 mg/ml) in a mixture of 1-propanol and de-ionized water (5:1 vol:vol), filtered through a 0.2 $\mu$m Nylon filter and finally inkjet printed (Dimatix DMP-2800) on the copolymer surface. The drop spacing setting was set to 40 $\mu$m and the printer-platen was heated to 30°C. Two layers of the polyelectrolyte were printed on top of each other to ensure a full coverage of the polyelectrolyte film over the underlying semiconducting copolymer layer. The thickness of the polyelectrolyte film was 0.5$\pm$0.1 $\mu$m as measured by a surface profilometer (Veeco, Dektak 3 ST). Finally, the devices were dried in a vacuum oven at 110°C for 90 s and to complete the fabrication of the OTFTs, a 60-nm-thick Ti gate electrode was thermally evaporated through a shadow mask. All the transistors had the same device geometry with channel length and width of $L$ = 3 $\mu$m and $W$ = 15 mm, respectively.

The characterization of the OFET: Contact angle measurements were obtained using a CAM 200 contact angle meter (KSV Instruments) and the photographs of the water droplets (7 $\mu$L) were analyzed using Attension Theta software (Biolin Scientific). Optical microscopy was performed using an Olympus MX-50 microscope. AFM micrographs were acquired with Dimension 3100 Scanning Probe Microscope (Digital Instruments) operated in tapping mode with Si cantilevers. Output and transfer characteristics were obtained by using a Keithley semiconductor characterization system (4200-SCS) at a scan rate of 0.3 V $s^{-1}$. To record switching transients, a square wave voltage (Agilent 33120A waveform generator) and a DC voltage (Agilent E3631A power supply) were applied to the gate and the drain electrode, respectively, while the voltage drop across a resistor (100 k$\Omega$) connecting the source to the ground was measured with an oscilloscope (Agilent 54832D Infiniium). A charging current of the gate capacitor was extracted from the transients by subtracting transient response at $V_D$ = 0 V from the response at $V_D$ = -0.5 V.

A top-gate/ bottom-contact field-effect transistors were fabricated by first spin coating a copolymer thin film on a glass substrate. The substrate was pretreated and provided with pre-patterned source and drain electrodes.

The coating step of the substrate was then followed by inkjet printing of a poly (vinylphosphonic acid- *co*- acrylic acid) (P (VPA- AA) ) polyelectrolyte film on the semiconducting copolymer film and finally the fabrication was completed by metal evaporating of the top gate electrode.

The organic field effect transistor was then tested. The output characteristics of the OFETs showed clear current modulation for drive voltages of less than 0.5 V, further shown in Figure 5a.

The ratio between the on and off current ($I_{D,on}$ / $I_{D,off}$) was roughly 67 which was extracted from the transfer characteristics, further shown in Figure 4b.

The field-effect mobility was about $\mu$ = $10^{-4}$ $cm^2V^{-1}s^{-1}$. This may be considered as rather low and attributed to the structural disorder of the copolymer films. Switching characteristics of the transistors: switch on and off times of the transistors were 1.1 ms and 0.2 ms which correspond to 90% and 10% of the final rise and fall response, respectively.

The output characteristics of the OFETs showed clear current modulation for drive voltages of less than 0.5 V (Figure 5b) . The ratio between the on and off current ($I_{D,on}$ / $I_{D,off}$) was roughly 67 which was extracted from the transfer characteristics (Figure 5c) . The field- effect mobility was determined from a (- $I_{D,sat}$)$^{1/2}$ vs. $V_G$ plot by fitting a straight line for $V_G$ <- 0.3 V and using the following equation $\mu = \frac{2L}{WC}\left(\frac{\partial}{\partial V_G}\sqrt{-I_{D,sat}}\right)^2$,

where C = 2 $\mu F/cm^2$ is the capacitance per unit area of the gate dielectric, $W$ = 15 mm and L = 3 $\mu$m the channel width and length and the last term in the parentheses is the slope of the fitted line. The resulting mobility $\mu$ = $10^{-4}$ $cm^2V^{-1}s^{-1}$ is rather low which is attributed to the structural disorder of the copolymer films. Switching characteristics of the transistors were obtained by applying a square- wave potential to the gate electrode while maintaining the drain electrode at a constant potential ($V_D$ =- 0.5 V) and subsequently measuring the source current. Switch on and off times of the transistors were 1.1 ms and 0.2 ms which correspond to 90% and 10% of the final rise and fall response, respectively.

Example 5

Synthesis of poly(3-hexylthiophene)-block-poly(N,N-dimethylaminoethyl methacrylate) (P3HT-b-PDMAEMA):

The polymerization was performed in anhydrous THF by using P3HT- Br, CuBr, and HMTETA as macroinitiator, catalyst, and ligand, respectively. The initial molar ratio was $[M]_0$: $[P3HT- MI]_0$: $[CuBr]_0$: $[HMTETA]_0$ = 100: 1: 1: 2. A dry flask was charged with CuBr (4.1 mg, 0.028 mmol), HMTETA (15.7 μl, 0.057 mmol), THF (1 ml), and a magnetic stirrer. The flask was fitted with a rubber septum and degassed with three successive vacuum nitrogen cycles. A second flask was charged with the P3HT- macroinitiator (200 mg, $M_n$ = 7000 g/mol, 0.02857 mmol), DMAEMA monomer (0.5 ml, 450 mg, 2.857 mmol), and THF (2 ml) . The flask was fitted with a rubber septum and degassed under nitrogen flow for a few minutes. The mixture was then transferred into the first flask and the polymerization was carried out under stirring at 60°C for 16 hours. The reaction was stopped by cooling down the reaction medium in liquid nitrogen. Then, THF was added to dilute the solution. Copper catalyst was removed by filtration of the THF solution through an alumina oxide column. The diblock copolymers were recovered by precipitation from cold heptane, filtration and drying up to constant weight. $^1$H NMR (300 MHz, CDCl3) ; d (ppm) : 6.96 (s, 1H), 5.29 (s, 2H), 4.06 (s, 2H), 2.78 (t, 2H), 2.57 (s, 2H), 2.28 (s, 6H), 1.90 (s, 2H), 1.69 (sex, 2H), 1.49 (q, 6H), 1.04 (s, 9H), 0.89 (t, 3H) . GPC, 19340 g/mol. PDI, 1.7.

Example 6:

Producing a field-effect transistor of bottom-gate/top-contact type comprising the cationic copolymer.

The device was manufactured by thermally evaporating (50 nm thick) gold (Au) on top of (5 nm thick) chromium (Cr) (bottom gate electrode) through a shadow mask on a Si/SiO2 wafer. A (100 nm thick) PSSH film (consisting of a mixture of 1:4 vol:vol PSSH to de-ionized water with 0.3% zonyl as a surfactant) was spin-coated on top of the gate electrode and annealed under vacuum at 110°C for 90 seconds. Then, a PSSH film treatment was performed by dipping the sample in a solution consisting of (0.01 mg/ml P3HT-b-PDMAEMA in toluene) for 1 minute. The samples were then ultrasonicated in toluene for 5 minutes to remove excess layers of the block copolymer of Example 5 and to break any micelles of the block copolymer in order to achieve good contact with the PSSH surface. After that, P3HT solution consisting of 4 mg/ml regioregular P3HT in 68% ortho-dichlorobenzene (oDCB) and 32% mesitylene was printed using the Dimatix material printer DMP-2800 forming a relatively continuous film (40 nm thick). The P3HT film was annealed under nitrogen at 120°C for 10 minutes. Finally, (100nm thick) Au was thermally evaporated through a shadow mask forming the source and drain top contacts. The channel length and width of the transistor were 10 μm and 700 μm respectively.

Example 7

Determination of surface wettability of films comprising the anionic copolymer

The surface wettability of the copolymer films obtained by Example 5 was determined by carrying out contact angle measurements. Contact angle measurements were recorded using a goniometer. As a reference, the homopolymeric P3HT surface was expectedly hydrophobic and the water contact angle remained constant at 104° throughout the duration of the experiment.

The measurement showed an that an untreated surface of PSSH contact angle of about 19 ° in DI water, and about 50° in hexadecane. A surface treated with the block copolymer as described in Example 5 shows a contact angle of about 45° in DI water, and about 39° in hexadecane.

X- ray photoelectron spectroscopy (XPS) measurements were performed using a Scienta ESCA 200 instrument. The result is shown in figure 6. The untreated electrolyte surface of PSSH is shown in figure 6a, while the surface of PSSH treated with the block copolymer is shown in Figure 6b (both with flat and tilted emission) . As the thiophene peak is shown in the XPS a successful treatement with cationic copolymer is concluded.

Example 8

Morphological characterization of the cationic copolymer surface was carried out to investigate the origin of the abrupt change in surface wettability from hydrophobic to hydrophilic. The surface was investigated with an Atomic force microscopy (AFM) (Veeco Dimension 3100 atomic force microscopy (AFM). The result is shown in Figure 7. Figures 7a and 7b shows the untreated electrolyte surface of PSHH. Figures 7c and 7d shows the surface treated with the cationic copolymer. The roughness of the treated surface is higher and the film has more texture than the untreated surface. The cationic copolymer forms a layer on top of the electrolyte (PSSH) having a different morphology than the untreated

surface. However, the surface is still smooth and provides a good template for the following process steps.

The surfaces were also analysed by optical microscopy images (figure 8). In figure 8a it shown that untreated surface of electrolyte generates an inhomogenous film of the printed semiconducting material P3HT. In figure 8b if is shown that the film of P3HT printed upon the cationic copolymer wets the film well and is moderately homogenous.

The OFET transistor was further tested and electrically characterized by using a parameter analyzer. The result is shown in figure 9, figure 9a and figure 9b shows the transfer and output respectively. The transfer characteristics shows that the on/off current ratio ($I_{on}/I_{off}$) is 40.

The leakage current (gate current) is typically less than one order of magnitude lower than $I_D$. The threshold is -0.66 V. The field effect mobility at saturation is estimated to be 0.023 $cm^2V^{-1}s^{-1}$.

The transistor characteristics reported here were measured with a Keithley 4200-SCS parameter analyzer. All electrical measurements were made in ambient air (relative humidity ca. 40%) at room temperature.

While the invention has been described with reference to a number of preferred embodiments, it will be understood by those skilled in the art that various changes may be made and equivalents may be substituted for elements thereof without departing from the scope of the invention. In addition, many modifications may be made to adapt a particular form or material to the teachings of the invention without departing from the essential scope thereof. Therefore, it is intended that the invention not be limited to the particular embodiments disclosed for carrying out the invention, but the invention will include all embodiments falling within the scope of the appended claims.

## Claims

**1.** An organic field effect transistor (OFET) device comprising:

an organic semiconductor layer;
a source electrode arranged in electronic contact with the said organic semiconductor;
a drain electrode arranged in electronic contact with the said organic semiconductor;
a gate electrode;
an electrolyte layer arranged between said gate electrode and said organic semiconductor layer;

wherein the organic semiconductor layer comprises a semiconducting polymeric material comprising one or more blocks of conjugated polymer (SC) combined with one or more blocks of copolymer (B); preferably an amphiphilic copolymer.

**2.** The device according to claim 1 wherein the conjugated polymer of the semiconducting material is of p-type.

**3.** The device according to any of claims 1 and 2, wherein the copolymer (B) is a polyanionic polymer (B1); preferably the polyanionic polymer (B1) comprises monomer units having sulphonic acid, carboxylic acid, phosphonic acid, or phosphoric acid groups, and salts thereof.

**4.** The device according to any of claims 1 to 3, wherein
the block co polymer is defined by formula Ia

$$SC\text{-}\ L_1\text{-}\ Z \qquad \text{formula Ia}$$

wherein the SC represents the semiconducting conjugated polymer;
Z represents the copolymer; and
$L_1$ represents a linker anchoring the polyanionic copolymer to the conjugated polymer forming the semiconducting polymer.

**5.** The device according to any of claims 1 to 4, wherein
the block co polymer is defined by formula Ib

$$SC_p\text{-}L_1\text{-}(M_m\text{- }Q_n)\text{-}$$

|

A

formula Ib

wherein the SC represents the semiconducting conjugated polymer;
$L_1$ represents a linker anchoring the polyanionic copolymer to the conjugated polymer forming the semiconducting polymer.
M represents a monomer unit forming the copolymer, and may be selected from methyl methacrylate, styrene, vinylpyridine, olephines;
Q represents monomer units carrying the anionic substituent in the copolymer;
A represents the anionic substituent. The anionic substituent may be selected from carboxylates, phosphonates, phosphates, sulfates, and sulfonates;
m represents an integer of between 0 and 100, preferably between 5 and 50, more preferably between 5 and 35.
n represents an integer of between 1 and 30, preferably between 1 and 20, more preferably between 1 and 10.
p represents an integer larger than 10, preferably larger than 40; preferably between 42 and 90;
with the provisos that $m < p$, and $n < p$.

**6.** The device according to claim 5, wherein the block co polymer is defined by formula Ib

$$SC_p\text{-}L_1\text{-}(M_m\text{- }Q_n)\text{-}$$

|

A

wherein
A may be further defined as $-L_2$-B- wherein $L_2$ represents a linker formed by sulfonebenzoic acid cyclic anhydride or propane sulfone;
B represents the anionic substituent selected from acrylic acid, methacrylic acid, phosphonic acid, sulphonic acid, and maleic acid.

**7.** The device according to any of claims 1 to 6, wherein conjugated polymer (SC) are selected from poly (alkylthiophene), poly (thienylene- vinylene), polyfluorene, polydiacetylene, poly (p- phenylene vinylene), or copolymers thereof; preferably from poly- 3- alkylthiophenes; more preferably from poly3- hexylthiophene (P3HT), poly (thienylene-vinylene), polyfluorene, polydiacetylene, poly (p- phenylene vinylene), or mixtures thereof.

**8.** The device according to any of claims 1 to 7, wherein the polyanionic copolymer is of formula Ic

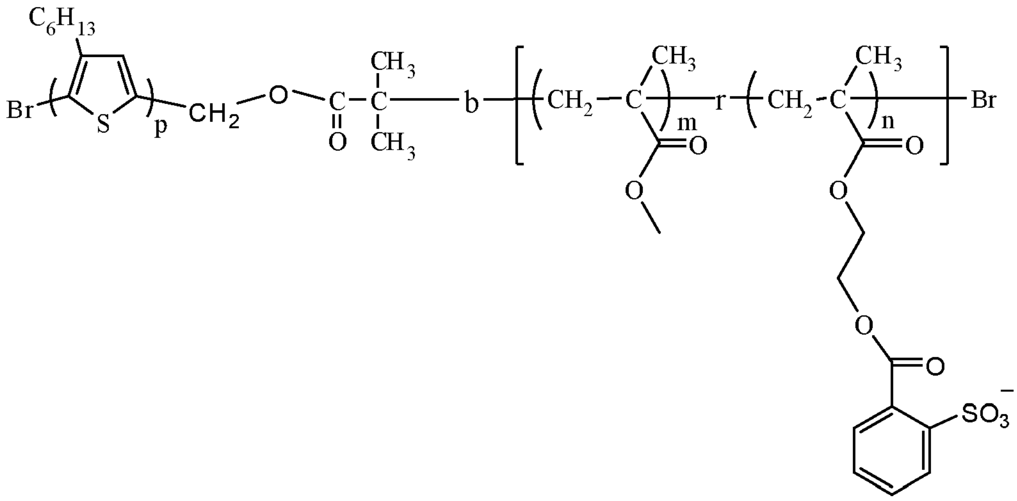

formula Ia

wherein
p represents an integer between 20 and 50;
m represents an integer between 10 and 30
n represents an integer between 3 and 15
b denotes the block of units
r denotes that the units within brackets are randomized placed with the proviso that $m < p$; and $n < p$; preferably m represents 23; n represents 8; p represents 43

**9.** The device according to any of claims 1 to 2 wherein the copolymer (B) is a polycationic polymer (B2).

**10.** The device according to any of claims 1 to 2 wherein the cationic copolymer is of formula IIa

$$SC\text{-}L_3\text{-}Y \qquad \text{formula IIa}$$

wherein the SC represents the semiconducting conjugated polymer;
Y represents the polycationic homo- or copolymer; and
$L_3$ represents a linker anchoring the polycationic homopolymer or copolymer (Y) to the conjugated polymer forming the semiconducting polymer.

**11.** The device according to claim 10 wherein the cationic copolymer is of formula IIb

$$\begin{array}{l} SC_p\text{-}L_4\text{-}(X_n)\text{-} \\ \qquad\qquad\quad | \\ \qquad\qquad\quad A_2 \end{array}$$

formula IIb

wherein the SC represents the semiconducting conjugated polymer;
$L_4$ represents a linker anchoring the polycationic copolymer to the conjugated polymer forming the semiconducting polymer.
X represents a monomer unit forming the copolymer, and may be selected from methacrylate, styrene, vinylpyridine, olefines;
Q represents monomer units carrying the cationic substituent in the copolymer;

$A_2$ represents the cationic substituent. The cationic substituent may be selected from alkylamine; preferably the alkyl may be a $C_1$-$C_6$ alkyl;
m represents an integer of between 0 and 200, preferably between 50 and 150, more preferably between 70 and 125;
p represents an integer larger than 10, preferably larger than 40, preferably, n represents 105; and p represents 42.

**12.** The device according to claim 11 wherein the block co polymer comprising cationic units is of formula IIc

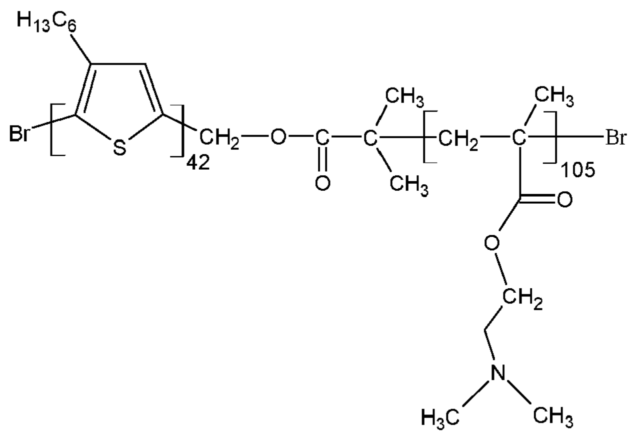

Formula II

**13.** The device according to claim 1 may be arranged on a substrate; preferably the substrate is selected from solid substrates; preferably the substrate is selected from flexible substrate.

**14.** The device according to any of claims 1 to 13 wherein the electrolyte layer comprises an electrolyte selected from polyvinyl alcohol (PVA), poly acrylic acid (PAA), PCPhOH (poly (vinyl phenol), polyvinyl sulphonic acid (PVSH), poly (styrene- 4- sulphonic acid (PSSH), polysaccharide, preferably amylase, poly (vinylphosponic acid- co- acrylic acid (P (VPA- co- AA) ), or mixtures thereof.

**15.** Method of producing the organic field effect transistor (OFET) device as defined in any of claims 1 to 14 comprising the steps:

providing a substrate;
applying an organic semiconductor layer;
applying a source electrode to be arranged in electronic contact with the said organic semiconductor;
applying a drain electrode arranged in electronic contact with the said organic semiconductor;
apply an electrolyte layer;
arrange a gate electrode so that the electrolyte layer is arranged between said gate electrode and said organic semiconductor layer.

**16.** The semiconducting conjugated polymer may be defined by formula Ia

$$SC\text{- }L_1\text{- }Z \qquad \text{Formula Ia}$$

wherein the SC represents the semiconducting conjugated polymer as defined herein;
Z represents the polyanionic copolymer as defined herein; and
$L_1$ represents a linker anchoring the polyanionic copolymer to the conjugated polymer forming the semiconducting polymer.

**17.** The semiconducting polymeric material according to any of claims
wherein the block copolymer is defined by formula Ib

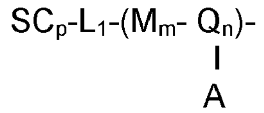

formula Ib

wherein the SC represents the semiconducting conjugated polymer; preferably selected from poly (alkylthiophene), poly (thienylene- vinylene), polyfluorene, polydiacetylene, poly (p- phenylene vinylene), or copolymers thereof; preferably from poly- 3- alkylthiophenes; more preferably from poly3- hexylthiophene (P3HT), poly (thienylene-vinylene), polyfluorene, polydiacetylene, poly (p- phenylene vinylene), or mixtures thereof;
$L_1$ represents a linker anchoring the polyanionic copolymer to the conjugated polymer forming the semiconducting polymer.
M represents a monomer unit forming the copolymer, and may be selected from the group of methyl methacrylate, styrene, vinylpyridine, and olefines; Q represents monomer units carrying the anionic substituent in the copolymer;
A represents the anionic substituent; preferably selected from carboxylates, phosponates, phosphates, sulfates, and sulfonates;
m represents an integer of between 0 and 100; preferably between 5 and 50; more preferably between 5 and 35;
n represents an integer of between 1 and 30; preferably between 1 and 20; more preferably between 1 and 10;
p represents an integer larger than 10; preferably larger than 40; for example an integer between 42 and 90
with the provisos that $m < p$, and $n < p$.

**18.** A semiconducting polymeric material according to any of claims 16 to 17 wherein
A is further defined as $-L_2$-B- wherein $L_2$ represents a linker;
B represents the anionic substituent selected from acrylic acid, methacrylic acid, phosponic acid, sulphonic acid, maleic acid.

**19.** The semiconducting polymeric material according to any of claims
wherein the block copolymer is defined by formula Ic

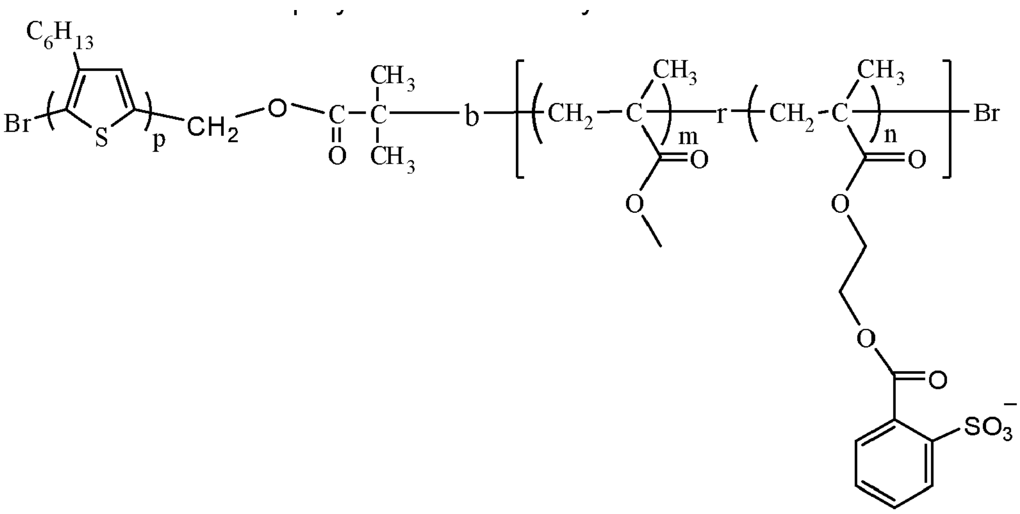

Formula Ic

wherein
m represents an integer between 10 and 30 n represents an integer between 3 and 15 p represents an integer between 20 and 50; b denotes the block of units r denotes that the units within brackets are randomized placed with the proviso that $m < p$; and $n < p$, preferably m represents 23; n represents 8; and p represents 43.

**20.** A semiconducting polymeric material according to any of claims 16 to 19 wherein the conjugated polymer (SC) is selected from poly (alkylthiophene), poly (thienylene- vinylene), polyfluorene, polydiacetylene, poly (p- phenylene vinylene), or copolymers thereof; preferably from poly- 3- alkylthiophenes; more preferably from poly3- hexylthiophene (P3HT), poly (thienylene- vinylene), polyfluorene, polydiacetylene, poly (p- phenylene vinylene), or mixtures thereof.

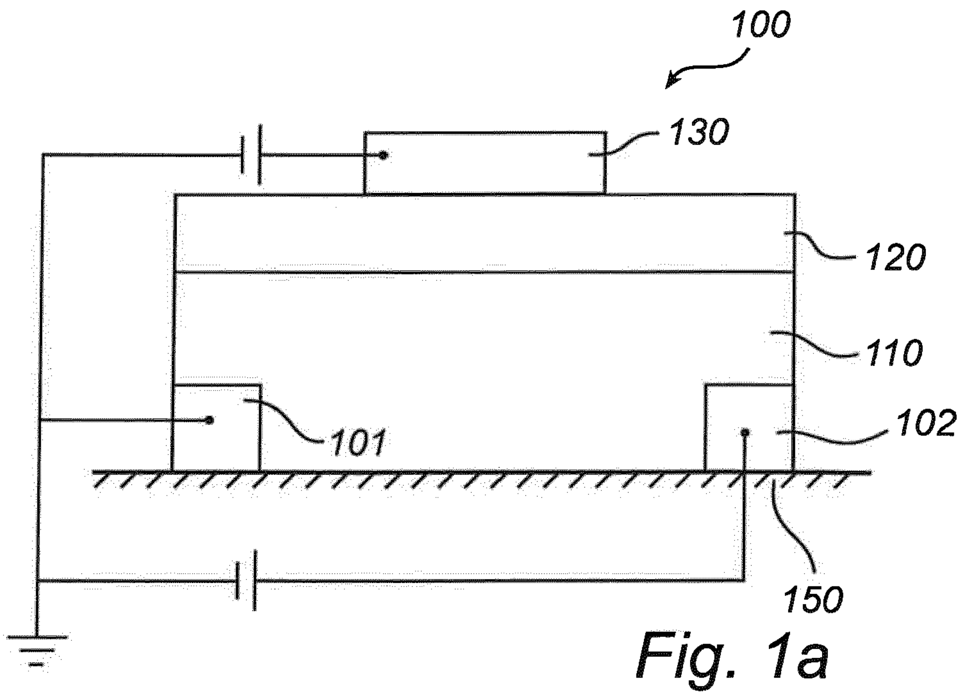


Fig. 1a

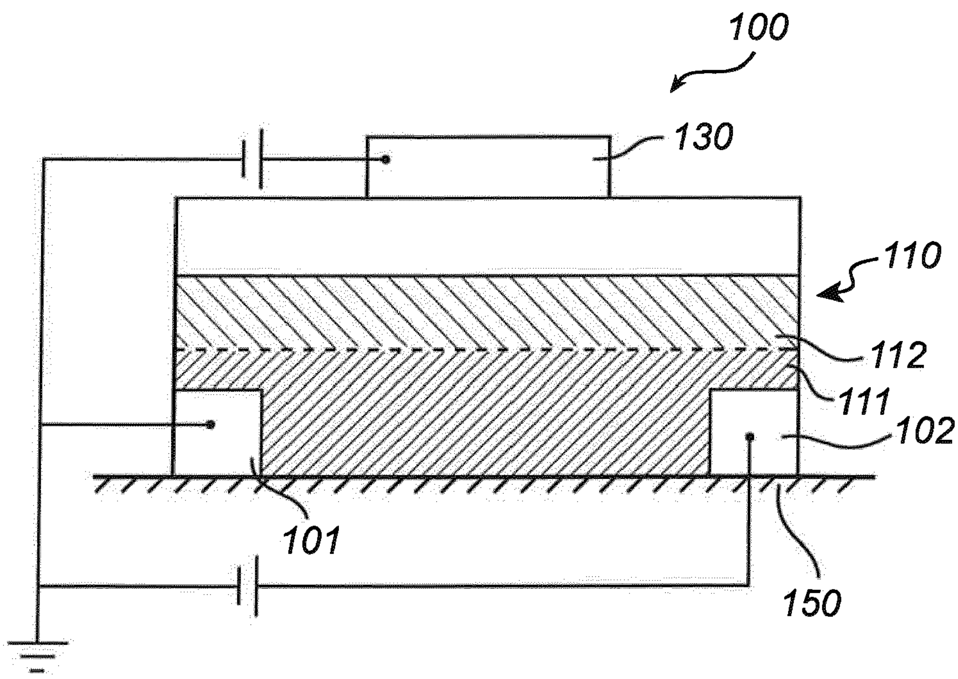


Fig. 1b

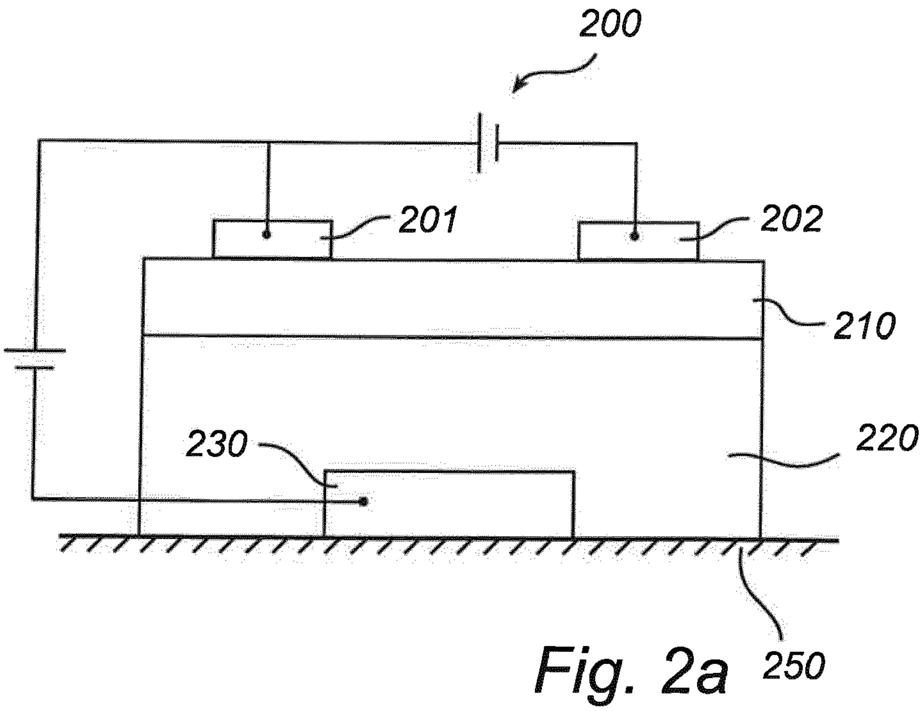


Fig. 2a

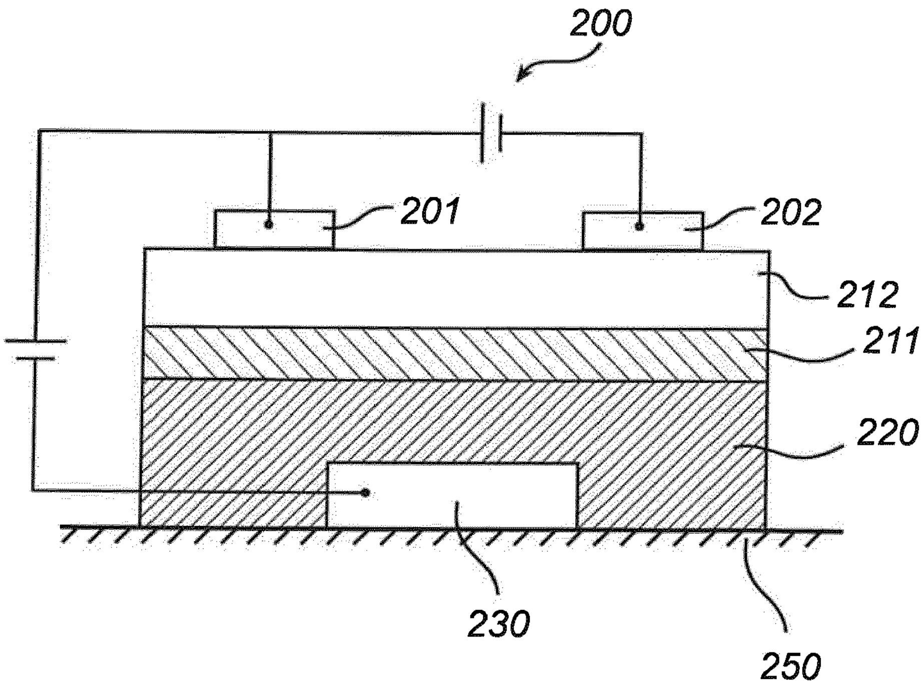


Fig. 2b

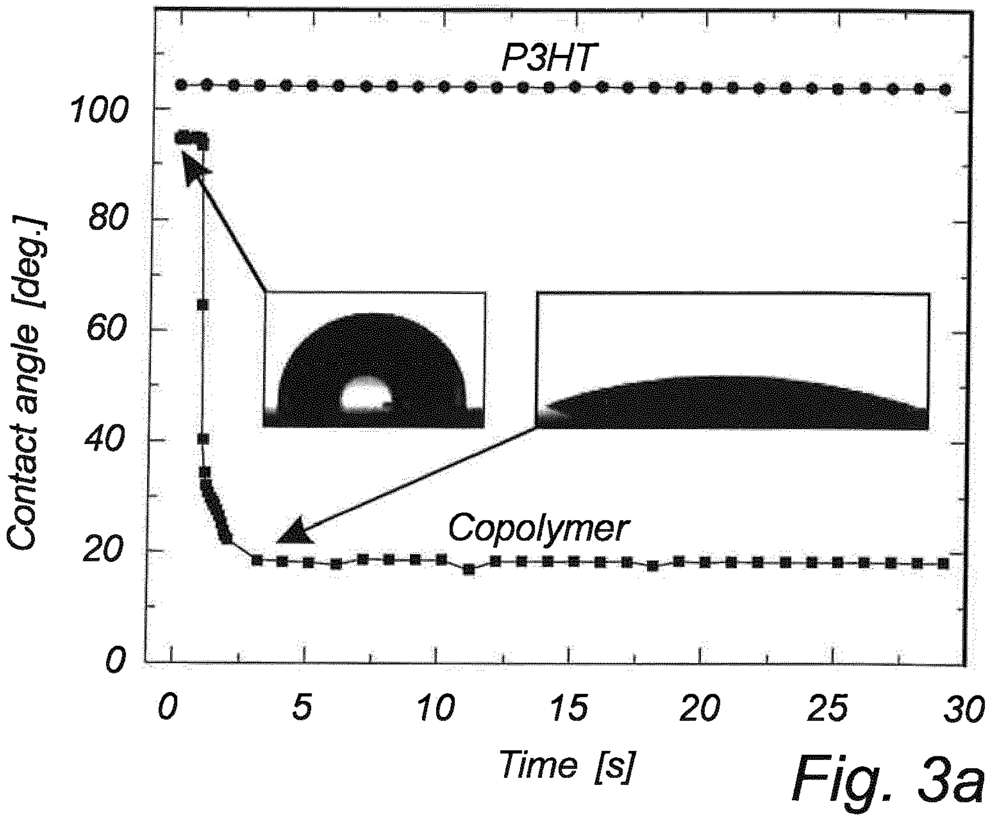


Fig. 3a

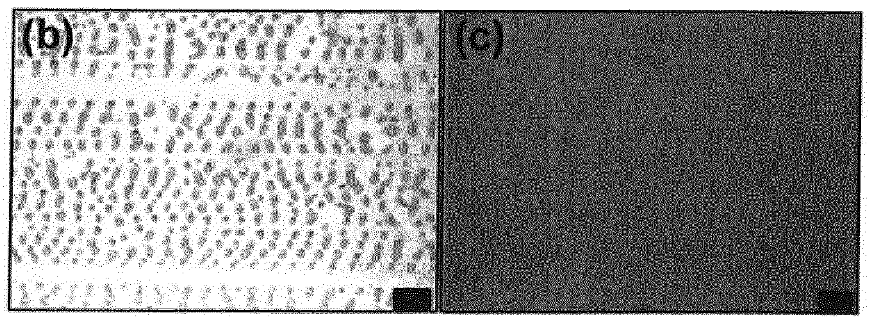


Fig. 3b Fig. 3c

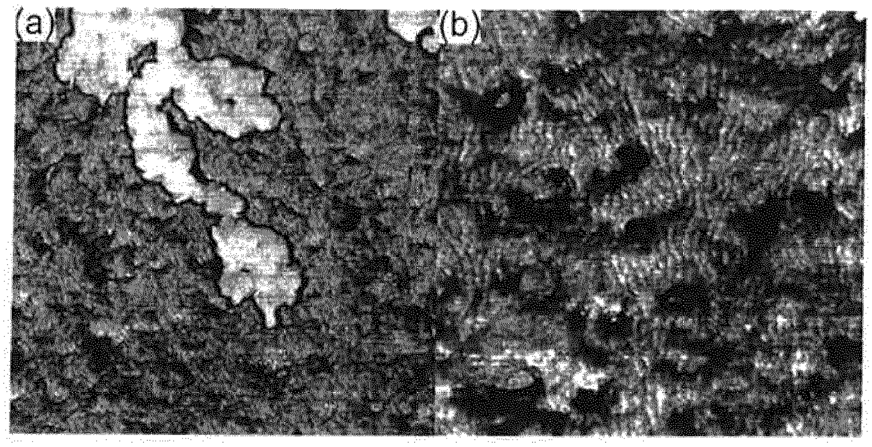


Fig. 4a Fig. 4b

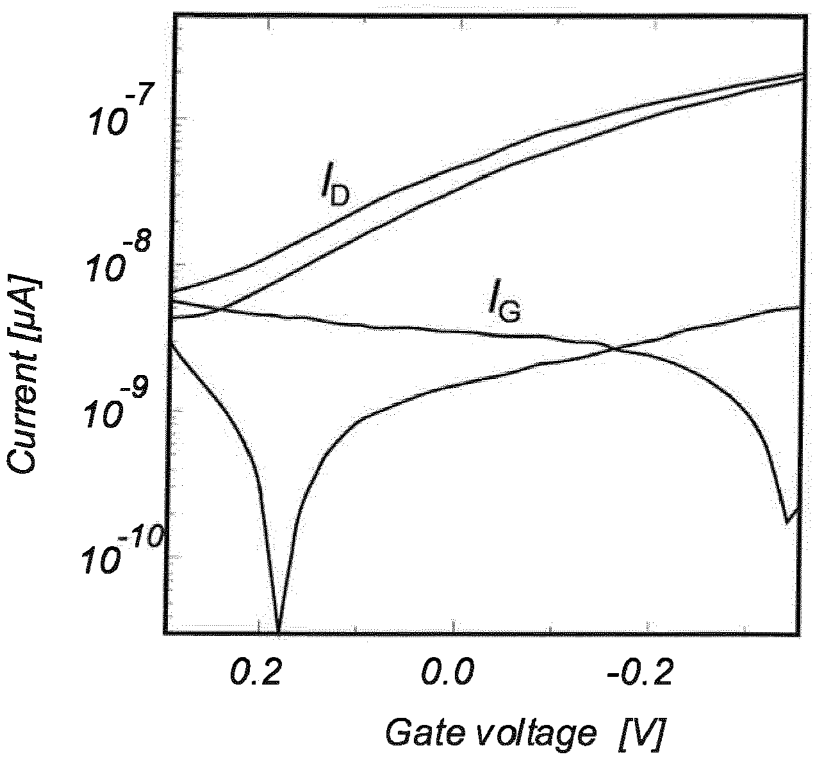


Fig. 5a

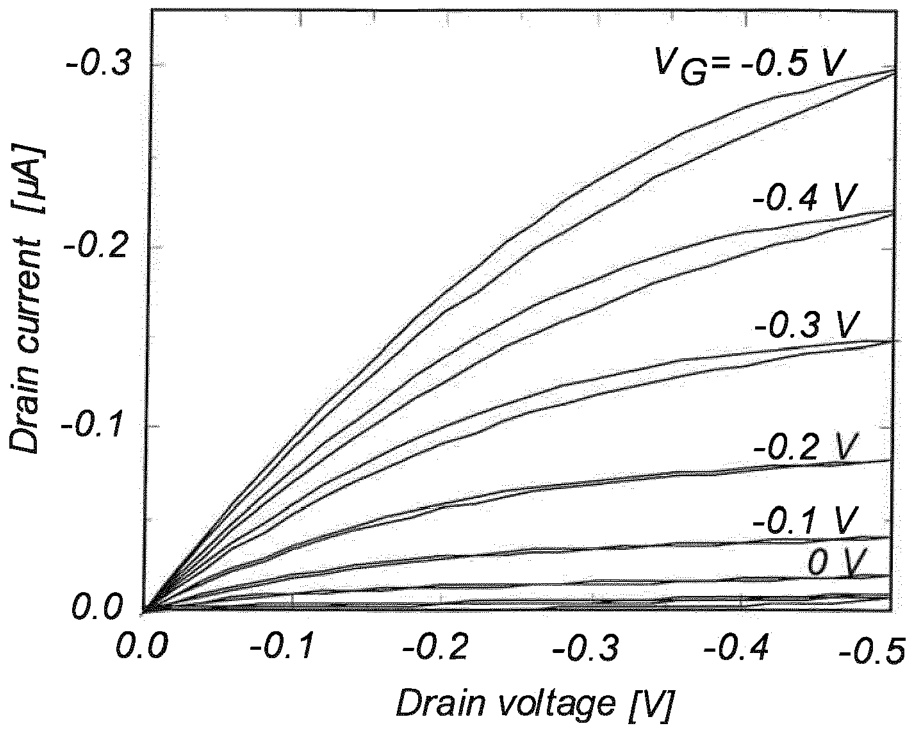
-0.3
-0.2
-0.1
0.0
Drain current [µA]
V_G= -0.5 V
-0.4 V
-0.3 V
-0.2 V
-0.1 V
0 V
0.0
-0.1
-0.2
-0.3
-0.4
-0.5
Drain voltage [V]

Fig. 5b

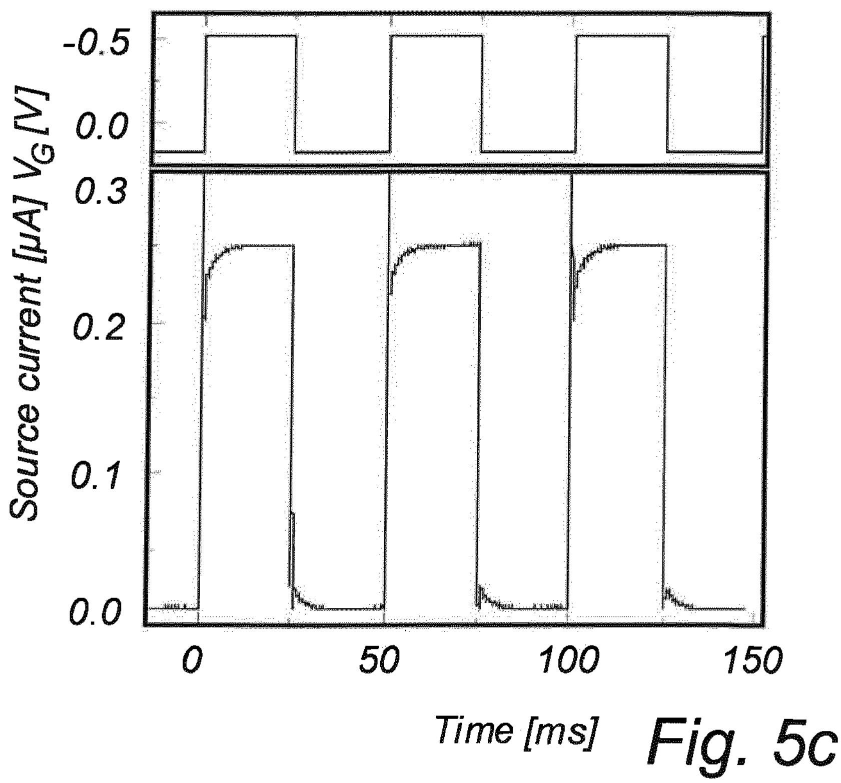
-0.5
0.0
0.3
0.2
0.1
0.0
Source current [µA] V_G [V]
0
50
100
150
Time [ms]

Fig. 5c

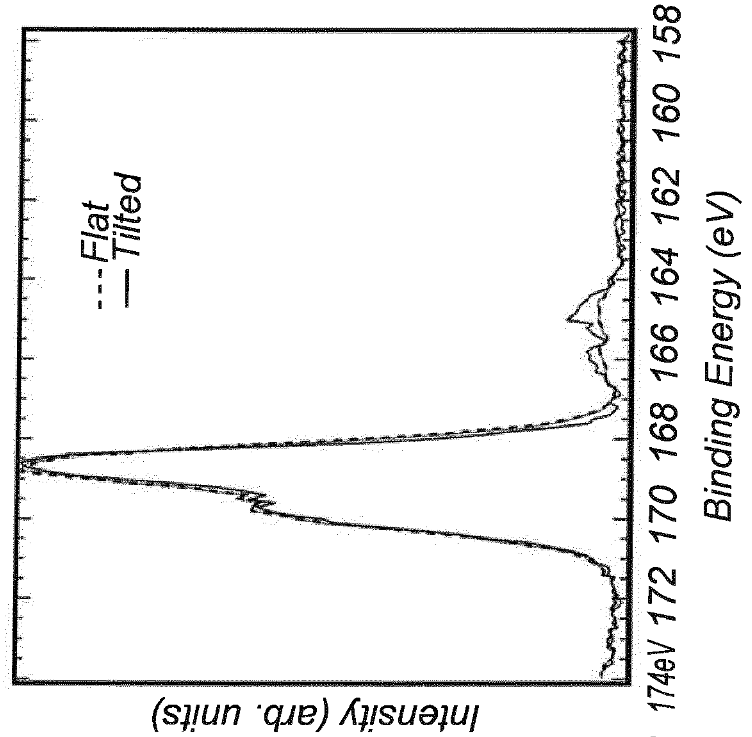

Flat
Tilted
Intensity (arb. units)
174eV 172 170 168 166 164 162 160 158
Binding Energy (eV)


Fig. 6b

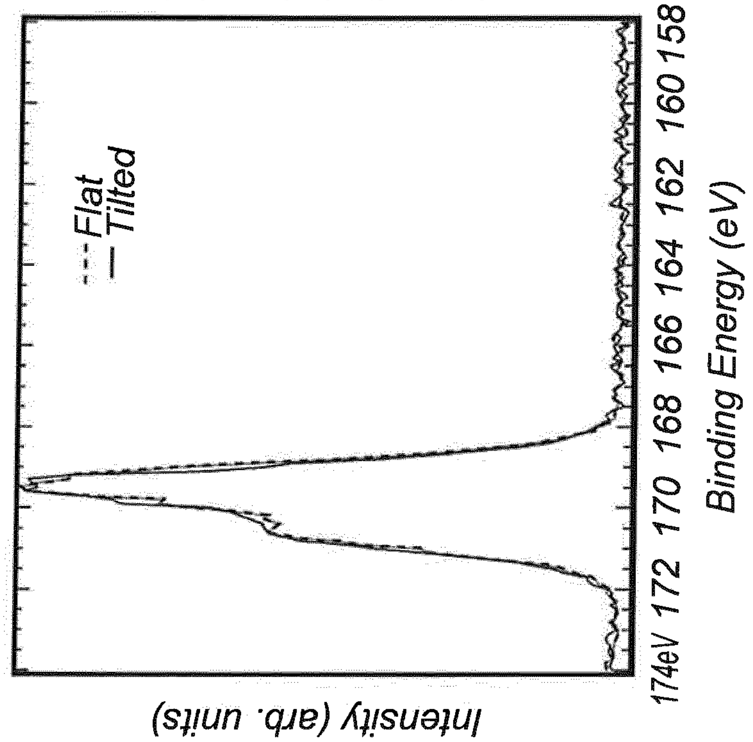

Flat
Tilted
Intensity (arb. units)
174eV 172 170 168 166 164 162 160 158
Binding Energy (eV)


Fig. 6a

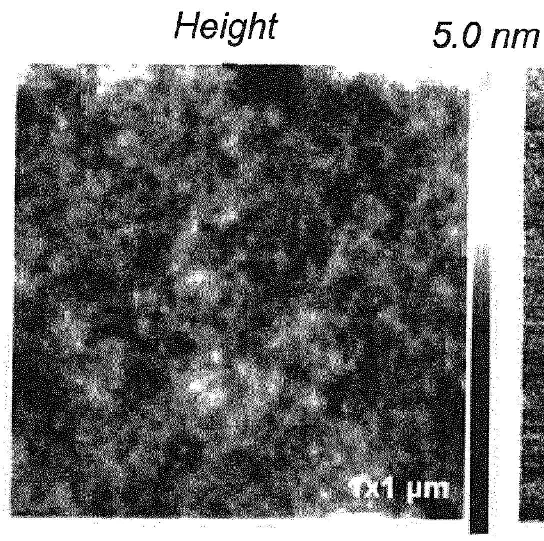


Fig. 7a

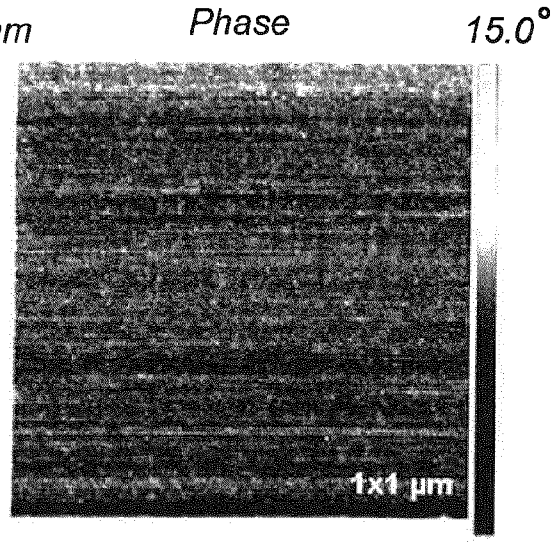


Fig. 7b

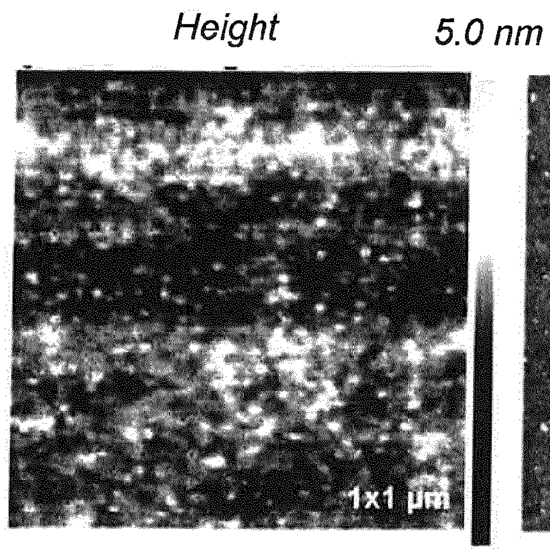


Fig. 7c

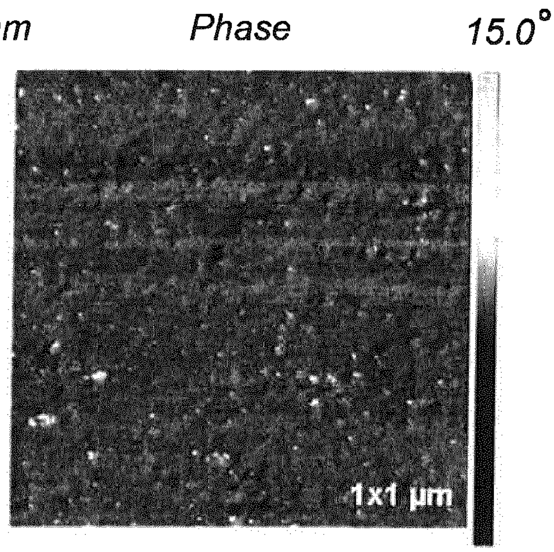


Fig. 7d

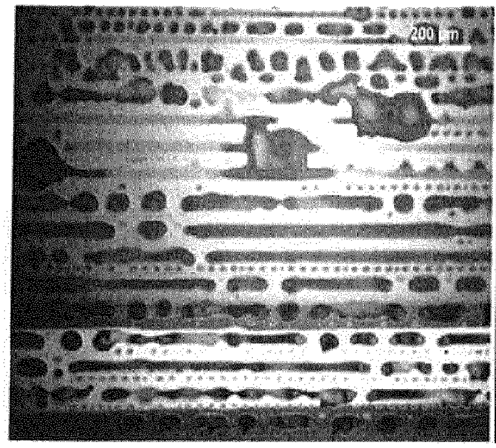


Fig. 8a

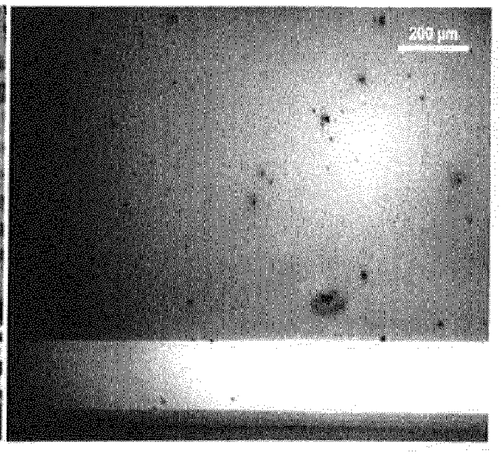


Fig. 8b

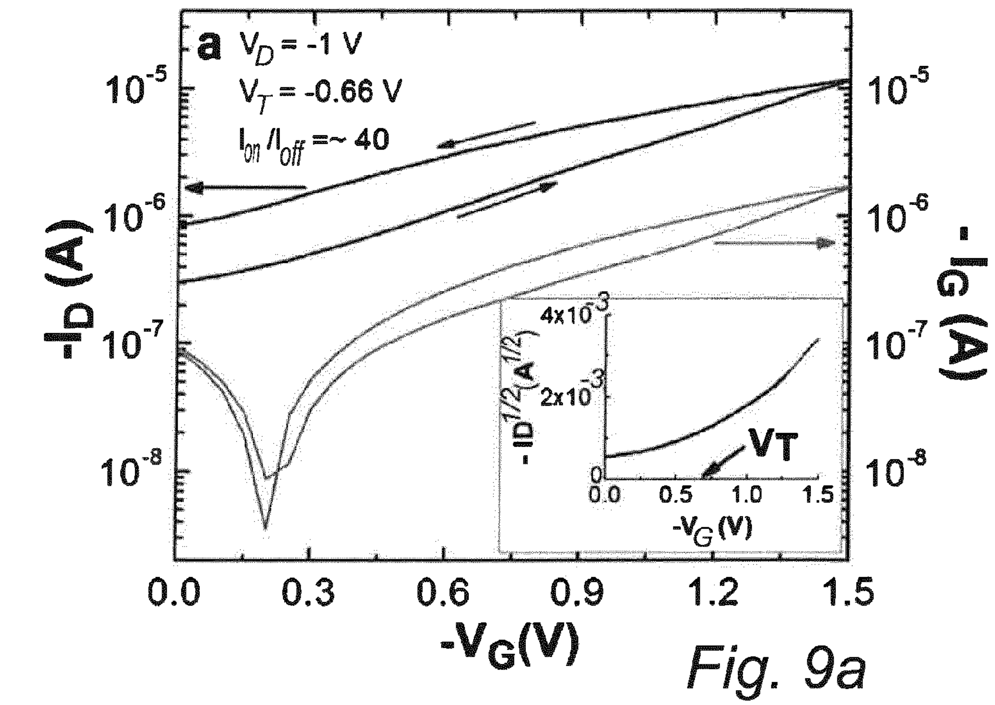
a
$V_D$ = -1 V
$V_T$ = -0.66 V
$I_{on}/I_{off}$ =~ 40
-$I_D$ (A)
- $I_G$ (A)
-$V_G$(V)
$-ID^{1/2}(A^{1/2})$
$V_T$

Fig. 9a

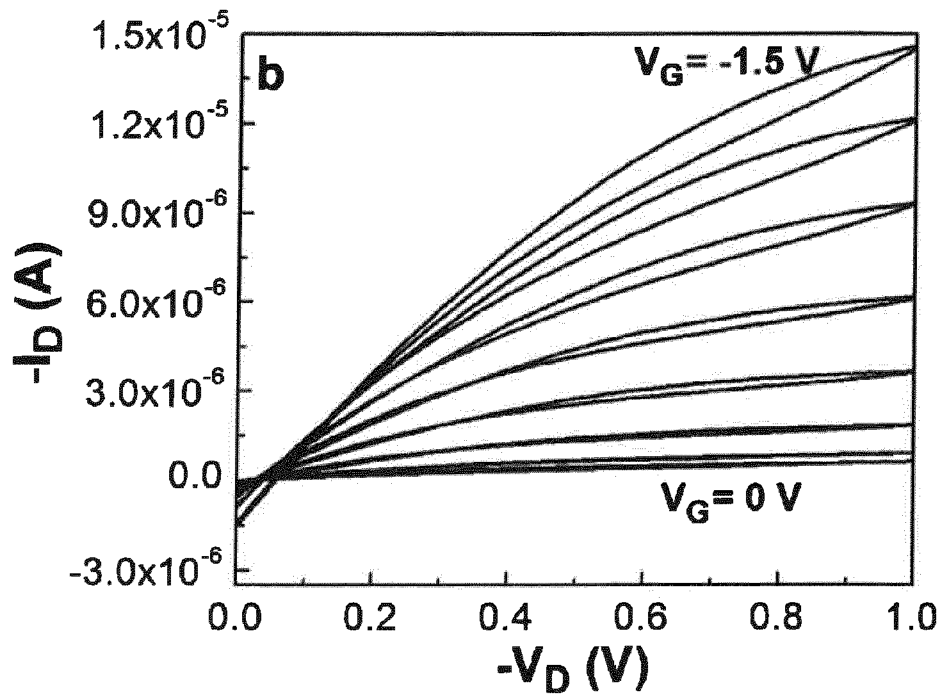
b
$V_G$= -1.5 V
$V_G$= 0 V
-$I_D$ (A)
-$V_D$ (V)

Fig. 9b

Europäisches Patentamt
European Patent Office
Office européen des brevets

# EUROPEAN SEARCH REPORT

Application Number
EP 12 16 4095

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LARS HERLOGSSON ET AL: "Polyelectrolyte-Gated Organic Complementary Circuits Operating at Low Power and Voltage", ADVANCED MATERIALS, vol. 23, no. 40, 25 October 2011 (2011-10-25), pages 4684-4689, XP55037688, ISSN: 0935-9648, DOI: 10.1002/adma.201101757<br>* page 4684, column 2, lines 20-39, 45 - page 4685, column 1, line 4; figure 1 *<br>* page 4685, column 1, lines 11-14 *<br>* page 4685, column 2, lines 6-12 *<br>----- | 1,2,4,7, 13-15 | INV.<br>H01L51/05 |
| Y | SAID E ET AL: "Effects of the ionic currents in electrolyte-gated organic field-effect transistors", ADVANCED FUNCTIONAL MATERIALS, WILEY - V C H VERLAG GMBH & CO. KGAA, DE, vol. 18, no. 21, 10 November 2008 (2008-11-10), pages 3529-3536, XP001517170, ISSN: 1616-301X, DOI: 10.1002/ADFM.200701251<br>* page 3530, column 1, line 19 - column 2, line 4; figure 1d *<br>----- | 1,9-12 | TECHNICAL FIELDS SEARCHED (IPC)<br>H01L |
| Y | HA TRAN NGUYEN ET AL: "Novel regioregular poly(3-hexylthiophene)-based polycationic block copolymers", POLYMER BULLETIN, SPRINGER, BERLIN, DE, vol. 66, no. 1, 16 March 2010 (2010-03-16), pages 51-64, XP019855589, ISSN: 1436-2449, DOI: 10.1007/S00289-010-0257-2<br>* page 57; figure Scheme 1 *<br>* page 62, line 21 - page 63, line 2 *<br>-----<br>-/-- | 1,9-12 | |

The present search report has been drawn up for all claims

1

| Place of search | Date of completion of the search | Examiner |
|---|---|---|
| The Hague | 12 September 2012 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 12 16 4095

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JIGUANG ZHANG ET AL: "Sulfonated Amphiphilic Block Copolymers: Synthesis, Self-Assembly in Water, and Application as Stabilizer in Emulsion Polymerization", MACROMOLECULES, vol. 42, no. 14, 28 July 2009 (2009-07-28), pages 5080-5090, XP55037820, ISSN: 0024-9297, DOI: 10.1021/ma900795f * figure 2 * ----- | 16-18,20 | |
| X | SHI Z ET AL: "SYNTHESIS AND PROTON CONDUCTIVITY OF PARTIALLY SULFONATED POLY(ÄVINYLIDENE DIFLUORIDE-CO-HEXAFLUOROPROPYLENEÜ-B-STYRENEÜ BLOCK COPOLYMERS", MACROMOLECULES, AMERICAN CHEMICAL SOCIETY, WASHINGTON, DC; US, vol. 38, no. 10, 17 May 2005 (2005-05-17), pages 4193-4201, XP001230201, ISSN: 0024-9297, DOI: 10.1021/MA0477549 * figure Scheme 1 * ----- | 16-18,20 | |
| | | | TECHNICAL FIELDS SEARCHED (IPC) |

The present search report has been drawn up for all claims

1

| Place of search | Date of completion of the search | Examiner |
|---|---|---|
| The Hague | 12 September 2012 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **E. SAID ; X. CRISPIN ; L. HERLOGSSON ; S. ELHAG ; N. D. ROBINSON ; M. BERGGREN.** Polymer field-effect transistor gated via a poly(styrenesulfonic acid) thin film. *Applied Physics Letters,* 2006, vol. 89 (14), 143507
- **L. HERLOGSSON ; X. CRISPIN ; N. D. ROBINSON ; M. SANDBERG ; O.J. HAGEL ; G. GUSTAFSSON ; M. BERGGREN.** Low-Voltage Polymer Field-Effect Transistors Gated via a Proton Conductor. *Advanced Materials,* 2007, vol. 19 (1), 97-101
- **A. LAIHO ; L. HERLOGSSON ; R. FORCHHEIMER ; X. CRISPIN ; M. BERGGREN.** Controlling the dimensionality of charge transport in organic thin-film transistors. *Proceedings of the National Academy of Sciences*
- *Polym. Bull.,* 2011, vol. 66, 51-64
- **X. HAN ; C. Y. LUO ; Y. GAO ; H. L. LIU.** *J. Macromol. Sci. Part B-Phys.,* 1994, vol. 49, 440
- **H. MORI ; A. HIRAO ; S. NAKAHAMA ; K. SENSHU.** *Macromolecules,* 1994, vol. 27, 4093